# EUROPÄISCHE PATENTSCHRIFT

(11) **EP 2 834 860 B1**
(45) Veröffentlichungstag und Bekanntmachung des Hinweises auf die Patenterteilung: **30.12.2015**
(21) Anmeldenummer: 13716186.5
(22) Anmeldetag: 13.03.2013
(51) Int. Cl.: H01L 39/22, H01L 39/24, H01L 39/02, H01L 39/12

(54) **REPRODUZIERBARERER STUFEN-JOSEPHSON-KONTAKT**
REPRODUCIBLE STEP-EDGE JOSEPHSON JUNCTION
JONCTION JOSEPHSON À GRADIN REPRODUCTIBLE

(30) Priorität: 04.04.2012 DE 102012006825; 15.12.2012 DE 102012024607
(43) Veröffentlichungstag der Anmeldung: 11.02.2015
(73) Patentinhaber: Forschungszentrum Jülich GmbH, 52425 Jülich (DE)
(72) Erfinder: FALEY, Mikhail, 52428 Jülich (DE)
(86) Internationale Anmeldenummer: PCT/DE2013/000146
(87) Internationale Veröffentlichungsnummer: WO 2013/149607

(56) Entgegenhaltungen:
- WO-A1-92/16974
- WO-A2-00/28605
- LEE S G ET AL: "Effects of d-wave symmetry in high Tc step-edge Josephson junctions", PHYSICA C, NORTH-HOLLAND PUBLISHING, AMSTERDAM, NL, Bd. 341-348, 1. November 2000 (2000-11-01) , Seiten 1473-1474, XP022714063, ISSN: 0921-4534, DOI: 10.1016/S0921-4534(00)01086-8 [gefunden am 2000-11-01]
- ALEXANDER D MASHTAKOV ET AL: "High- Superconducting Step-Edge Junction on Sapphire Fabricated by Non-Etching Technique", IEEE TRANSACTIONS ON APPLIED SUPERCONDUCTIVITY, IEEE SERVICE CENTER, LOS ALAMITOS, CA, US, Bd. 9, Nr. 2, 1. Juni 1999 (1999-06-01), XP011082649, ISSN: 1051-8223
- GIVARGIZOV: "Graphoepitaxy as an approach to oriented crystallization on amorphous substrates", JOURNAL OF CRYSTAL GROWTH, ELSEVIER, AMSTERDAM, NL, Bd. 310, Nr. 7-9, 1. April 2008 (2008-04-01), Seiten 1686-1690, XP022697512, ISSN: 0022-0248, DOI: 10.1016/J.JCRYSGRO.2007.11.052 [gefunden am 2007-11-19]

## Beschreibung

Die Erfindung betrifft ein elektronisches Bauelement mit einem Josephson-Kontakt sowie ein Verfahren zur Herstellung.

### Stand der Technik

Josephson-Kontakte zwischen hochtemperatursupraleitenden (High-T_{c}, HTSL) Elektroden sind ein Grundbaustein der supraleitenden Elektronik. Sie werden unter anderem für supraleitende Quanteninterferometer (SQUIDs) zur hochempfindlichen Magnetfeldmessung und in Detektoren für THz-Strahlung eingesetzt.

Die wesentlichen Kenngrößen eines Josephson-Kontakts sind die kritische Stromdichte J_{c} des supraleitenden Zustandes und der Widerstand Rₙ im normalleitenden Zustand. Diese Größen und insbesondere ihr Produkt J_{c}*Rₙ (bzw. I_{c}*Rₙ mit dem kritischen Strom I_{c}) sind als Gütemaß für die Anwendbarkeit von Josephson-Kontakten zu den genannten Zwecken aus (E. Mitchell, C. P. Foley, "YBCO step-edge junctions with high IcRn", Superconductor Science and Technology 23, 065007 (2010), doi:10.1088/0953-2048/23/6/065007) bekannt. Diese Schrift offenbart, dass sowohl J_{c} als auch Rₙ an der Korngrenze einer YBCO-HTSL-Schicht stark vom Winkel θ zwischen den Kristallorientierungen der beiden Körner im YBa₂Cu₃O₇₋ₓ (YBCO) abhängen. Daher wird vorgeschlagen, die Schicht auf einem Substrat aufzuwachsen, dessen Oberfläche eine Stufenkante enthält. Der Josephson-Kontakt entsteht an der oberen Kante einer rutschbahnförmigen Stufe der Substratsoberfläche, indem an der Kante in die Kristallstruktur von YBCO ein scharfer Knick mit einem Winkel von θ Grad eingebracht wird. Dabei bildet sich im YBCO an der Stufenkante eine Korngrenze, wobei der Winkel θ durch den Knickwinkel der Stufenkante vorgegeben ist. Der Knick bewirkt eine lokale Verspannung und damit ein lokales Sauerstoffdefizit im YBCO an der Korngrenze. Dadurch wirkt der Bereich des Knicks wie eine Tunnel-Kontakt-Barriere zwischen zwei unterschiedlich orientierten D-Wellen-Supraleitern und bildet somit das Weak-Link des Josephson-Kontakts.

Einige der auf diese Weise hergestellten Josephson-Kontakte weisen das erhoffte hohe Produkt I_{c}*Rₙ tatsächlich auf. Nachteilig genügt die Reproduzierbarkeit bislang nur für den Nachweis der prinzipiellen Machbarkeit (proof-of-concept), nicht jedoch für die großtechnische Fertigung, da sehr viel Ausschuss entsteht.

Soon-Gul Lee et al. ("Effects of d-wave symmetry in high Tc step-edge Josephson junctions", Physica C, Vol. 341-348, p. 14873-1474) sowie Alexander D. Mashtakov et al. ("High Tc superconducting step-edge junction on sapphire fabricated by non-etching technique", IEEE Transactions on Applied Superconductivity, Vol. 9, No. 2, p 3001-3004 (1999)) zeigen ein Bauelement mit einem Josephson-Kontakt, umfassend ein Substrat mit mindestens einer Stufenkante in seiner Oberfläche und eine darauf angeordnete Funktionsschicht aus einem hochtemperatursupraleitenden Material YBCO, wobei diese Schicht an der Stufenkante eine Korngrenze aufweist, die das Weak-Link des Josephson-Kontakts bildet, wobei auf beiden Seiten der Stufenkante die a- und/oder die b-Kristallachse in der Ebene der hochtemperatursupraleitenden Funktionsschicht durch eine Texturierung des Substrats bis auf eine Abweichung von beispielsweise höchstens 10° senkrecht auf die Korngrenze ausgerichtet ist.

Nachteilig bei den nach dem Stand der Technik bekannten Bauteilen ist es, dass die Orientierung der Funktionsschicht an die natürliche Orientierung der Kristallstruktur der Substratschicht bzw. der Pufferschicht angepasst werden muss. Auch in WO 92/16974 A1 weist das Substrat bzw. die Pufferschicht bereits eine Kristallorientierung auf. Diese Orientierung ist insbesondere nicht immer optimal, um auf der Flanke der Stufe eine einheitliche Orientierung der Funktionsschicht zu erzwingen. So wird etwa in Soon-Gul Lee et al. ("Effects of d-wave symmetry in high Tc step-edge Josephson junctions", Physica C, Vol. 341-348, p. 14873-1474) die c-Achse der Funktionsschicht auf der Flanke der Stufe nicht einheitlich in die Normale zu dieser Flanke gezwungen, sondern richtet sich in statistischer Weise parallel oder senkrecht zur c-Achse in den flachen Bereichen zu beiden Seiten der schrägen Stufenflanke aus. Dementsprechend zerfällt die Funktionsschicht auf der Stufenflanke in eine Vielzahl von Domänen mit unterschiedlich ausgerichteten c-Achsen. Sie weist daher auf der Stufenflanke eine Vielzahl von Korngrenzen auf, die die elektrischen Eigenschaften des Josephson-Kontakts verschlechtern.

### Aufgabe und Lösung

Es ist daher die Aufgabe der Erfindung, Josephson-Kontakte aus Hochtemperatursupraleitern zur Verfügung zu stellen, die ein hohes Produkt I_{c}*Rₙ aufweisen und sich zugleich reproduzierbarer herstellen lassen als nach dem bisherigen Stand der Technik.

Es ist weiterhin Aufgabe der Erfindung, die Orientierung der Funktionsschicht von der natürlichen Orientierung des Substrats und/oder einer Pufferschicht zu entkoppeln und somit die Möglichkeit zu schaffen, die Orientierung der a- und/oder b-Kristallachsen der Funktionsschicht unabhängig vom Material des Substrats und/oder der Pufferschicht auf die Korngrenze auszurichten.

Diese Aufgabe wird erfindungsgemäß gelöst durch ein Bauelement mit einem Josephson-Kontakt gemäß Ansprüchen 1 und 2 sowie durch ein Herstellungsverfahren gemäß Ansprüchen 15 und 16. Weitere vorteilhafte Ausgestaltungen ergeben sich aus den darauf rückbezogenen Unteransprüchen. Gegenstand der Erfindung sind weiterhin ein Detektor für THz-Strahlung und ein SQUID, bei denen das erfindungsgemäße Bauelement Verwendung findet.

### Gegenstand der Erfindung

Im Rahmen der Erfindung wurde ein Bauelement mit einem Josephson-Kontakt entwickelt. Dieses Bauelement umfasst ein Substrat mit mindestens einer Stufenkante in seiner Oberfläche und eine darauf angeordnete Schicht aus einem hochtemperatursupraleitenden Material, wobei diese Schicht an der Stufenkante eine Korngrenze aufweist, die das Weak-Link des Josephson-Kontakts bildet. Diese Schicht wird im Folgenden als Funktionsschicht bezeichnet.

Unter der Stufenkante wird nicht die Außenkante des Substrats verstanden, an der das Substrat und damit auch die darauf befindliche HTSL-Schicht endet. Eine Stufenkante im Sinne dieser Erfindung ist vielmehr eine Kante, die sich innerhalb des Oberflächenbereichs des Substrats befindet, so dass die auf dem Substrat befindliche HTSL-Schicht sich zu beiden Seiten dieser Stufenkante erstreckt.

Erfindungsgemäß ist auf beiden Seiten der Stufenkante die *a*- und/oder die *b*-Kristallachse in der Ebene der hochtemperatursupraleitenden Schicht (Funktionsschicht) durch eine Texturierung des Substrats und/oder mindestens einer zwischen dem Substrat und der hochtemperatursupraleitenden Schicht (Funktionsschicht) angeordneten Pufferschicht bis auf eine Abweichung von höchstens 10° senkrecht auf die Korngrenze ausgerichtet. Dies lässt sich technisch beispielsweise realisieren, indem die HTSL-Schicht (Funktionsschicht) graphoepitaktisch auf der texturierten Oberfläche aufgewachsen wird.

Das erfindungsgemäße Bauelement lässt sich somit alternativ dadurch kennzeichnen, dass die hochtemperatursupraleitende Funktionsschicht graphoepitaktisch auf ein texturiertes Substrat und/oder eine zwischen dem Substrat und der hochtemperatursupraleitenden Funktionsschicht angeordnete texturierte Pufferschicht aufgewachsen ist. Durch die Texturierung ist auf beiden Seiten der Stufenkante die *a*- und/oder die *b*-Kristallachse in der Ebene der hochtemperatursupraleitenden Funktionsschicht bis auf eine Abweichung von höchstens 10° senkrecht auf die Korngrenze ausgerichtet.

Unter der Ausrichtung der *a*- bzw. *b*-Achse der HTSL-Schicht wird verstanden, dass die Achsen von über *90 %* der Körner, aus denen die HTSL-Schicht zusammengesetzt ist, ausgerichtet sind. Es gibt in der Regel immer einzelne Körner mit falscher Ausrichtung, aber die spielen dann keine große Rolle mehr für den Stromtransport.

Unter der Ausrichtung sowohl der *a*- als auch der *b*-Achse wird verstanden, dass ein Teil der Körner mit ihrer *a*-Achse und ein Teil der Körner mit ihrer *b*-Achse senkrecht zur Stufenkante ausgerichtet ist.

Es wurde erkannt, dass die supraleitenden Eigenschaften von HTSL-Schichten in der Schichtebene sehr anisotrop sind. Die Wellenfunktion der Cooper-Paare, die den Suprastrom tragen, hat entlang der Kristallachsen *a* und *b* in der Schichtebene eine große Amplitude, wobei sie entlang der Kristallachse *b* eine gegenüber der Kristallachse *a* um 180° versetzte Phase hat. In der Richtung unter 45° zu den beiden Kristallachsen *a* und *b* der HTSL-Schicht ist die Amplitude der Wellenfunktion der Cooper-Paare gleich Null. Ein hoher Suprastrom kann also im Wesentlichen nur entlang der Kristallachsen *a* und *b* transportiert werden. Damit der Suprastrom auch über die Stufenkante hinweg transportiert werden kann, ist es notwendig, dass zu beiden Seiten der Stufenkante die Kristallachse *a* oder *b* der HTSL-Schicht zur Stufenkante hin ausgerichtet ist. Ist dagegen auf wenigstens einer Seite der Stufenkante die Kristallstruktur im Winkel von 45° zur *a*- und *b-* Achse ausgerichtet, fließt kein Suprastrom (I_{c} = 0) über den Josephson-Kontakt. Außerdem entstehen in diesem Fall die Null-Energie-Zustände, welche den normalleitenden Widerstand Rₙ (und damit auch der Produkt I_{c}*Rₙ) des Josephson-Kontakts drastisch senken.

Indem somit zu beiden Seiten der Stufenkante die *a*- und/oder b- Kristallachse jeweils senkrecht auf die Stufenkante ausgerichtet ist, kann ein maximaler Suprastrom über die durch die Stufenkante induzierte Korngrenze und damit über den Josephson-Kontakt fließen. Nach dem bisherigen Stand der Technik wurde die In-Plane-Ausrichtung der *a*- und *b*-Achse in der Schichtebene nicht kontrolliert, sondern bildete sich zufällig aus. Die hergestellten Schichten enthielten daher auch viele Körner, bei denen die *a*- und/oder *b*-Achse einen Winkel von 45° mit der Stufenkante bildete; somit war der Stromtransport durch diese Körner gerade in der interessierenden Richtung minimal.

In einer besonders vorteilhaften Ausgestaltung der Erfindung ist zwischen der hochtemperatursupraleitenden Schicht (Funktionsschicht) und dem Substrat eine antiepitaktische Pufferschicht angeordnet, wobei diese antiepitaktische Pufferschicht entweder amorph ist oder eine nicht zum Substrat und/oder zur hochtemperatursupraleitenden Schicht epitaxiekompatible Kristallstruktur aufweist, so dass die *c*-Achse der hochtemperatursupraleitenden Schicht (Funktionsschicht) sich nach der energetisch günstigsten eigenen Wachstumsrichtung orientiert und damit bis auf eine Abweichung von höchstens 10° senkrecht zu der Schichtebene steht. Dabei folgt die Schichtebene dem Knick in der Substratoberfläche. Für die Antiepitaxie es ist wichtig, dass die Ausrichtung der Schicht nach ihrem eigenen Phasendiagramm, etwa auf Grund des geschichteten Aufbaus von YBCO-Schichten, gegenüber der Ausrichtung entsprechend der Kopplung zum Substrat energetisch bevorzugt ist. Die hochtemperatursupraleitenden Funktionsschichten, insbesondere YBCO-Schichten, sollen ihrer natürlichen Tendenz folgen, schneller in der Schichtebene zu wachsen als in *c*-Richtung senkrecht zur Schichtebene. Das kann man erreichen mit einer dünnen amorphen Schicht oder mit einer so stark epitaktisch inkompatiblen Schicht, dass auf dem Interface zur HTSL-Schicht sehr viele Verspannungen gebildet sind. Eine dritte Möglichkeit ist eine sehr dünne (etwa 1 nm, bevorzugt 0,3 bis 1 nm) antiepitaktische Schicht aus einem Material mit Kristallstruktur-Parametern, die sich stark von den Kristallstruktur-Parametern des Substrats unterscheiden. In diesen Fall wirken beide Kristallstrukturen auf die Ausrichtung der HTSL-Schicht und schwächen dabei ihre Auswirkung auf die HTSL-Schicht gegenseitig ab.

Beispielsweise kann auf einem MgO-Substrat eine erste epitaktische Schicht aus Yttrium-stabilisiertem Zirkonoxid (YSZ) angeordnet sein, die als Vermittler für die eigentliche antiepitaktische Schicht aus CeO₂ dient. Hierauf kann die supraleitende YBCO-Schicht angeordnet sein.

Eine antiepitaktische Pufferschicht gemäß der Erfindung bewirkt, dass sich die c-Achse der HTSL-Schicht auch dann senkrecht zur Schichtebene orientiert, wenn das Substrat eine zur HTSL-Schicht kompatible Kristallstruktur und Gitterkonstante aufweist. Dadurch ist gewährleistet, dass sich an der Stufenkante grundsätzlich eine Korngrenze in der HTSL-Schicht ausbildet. An der Kante der rutschbahnförmigen Stufe bewirkt der Knick in der Substratoberfläche einen scharfen Knick in der Kristallstruktur der HTSL-Schicht, so dass ein Josephsohn-Kontakt entsteht. Bei epitaktischem, am Substrat orientiertem Wachstum dagegen entsteht bei Stufen-Winkeln θ < 45, bevorzugt < 19°, keine Korngrenze an der Stufenkante, so dass dort kein Josephson-Kontakt gebildet wird. Mit einer, vorzugsweise dünnen, antiepiktaktischen Zwischenschicht ist außerdem sichergestellt, dass sowohl die *a*- als auch die *b*-Achse in der Schichtebene liegen und ein Stromtransport durch die Schicht in zwei Dimensionen erleichtert ist. Die Kontrolle über die *a*- und *b*- Achse ist mit einer In-Plane-Texturierung möglich.

Vorteilhaft weist die antiepitaktische Pufferschicht eine Dicke von 10 nm oder weniger, bevorzugt von 1 nm oder weniger und ganz besonders bevorzugt von 0,5 nm oder weniger auf. Sofern sich die Texturierung im Substrat oder in einer weiteren Schicht zwischen der antiepitaktischen Pufferschicht und dem Substrat befindet, ist durch diese geringe Schichtdicke gewährleistet, dass die Texturierung noch einen maßgeblichen Einfluss auf die Kristallorientierung der HTSL-Schicht in der Schichtebene haben kann.

Vorteilhaft liegt jede Gitterkonstante der antiepitaktischen Pufferschicht in der Schichtebene näher an den Gitterkonstanten *a* und *b* in der Ebene der hochtemperatursupraleitenden Schicht (Funktionsschicht) als an jedem ganzzahligen Vielfachen oder Teiler der Gitterkonstante c dieser Schicht. Dadurch wird vermieden, dass sich die *c*-Achse der HTSL-Schicht in die Ebene der antiepitaktischen Pufferschicht orientiert.

In einer besonders vorteilhaften Ausgestaltung ist die antiepitaktische Pufferschicht texturiert. Dann steht diese Texturierung in unmittelbarem Kontakt mit der HTSL-Schicht und wirkt maximal auf deren Kristallausrichtung in der Ebene.

Alternativ oder auch in Kombination hierzu ist in einer weiteren besonders vorteilhaften Ausgestaltung der Erfindung zwischen dem Substrat und der antiepitaktischen Pufferschicht oder zwischen der antiepitaktischen Pufferschicht und der hochtemperatursupraleitenden Schicht (Funktionsschicht) eine weitere texturierte Pufferschicht angeordnet. Dann sind die Funktionen der beiden Pufferschichten voneinander getrennt und können unabhängig voneinander optimiert werden. Damit der Einfluss der texturierten Pufferschicht auf die Kristallorientierung der HTSL-Schicht in der Schichtebene gegenüber dem Einfluss der antiepitaktischen Pufferschicht überwiegt, ist die texturierte Pufferschicht vorteilhaft um mindestens 20 %, bevorzugt um mindestens 50 % und ganz besonders bevorzugt um mindestens 100 % dicker als die antiepitaktische Pufferschicht. Vorteilhaft weist sie jedoch gleichzeitig eine Dicke von 10 nm oder weniger, bevorzugt von 1 nm oder weniger und ganz besonders bevorzugt von 0,5 nm oder weniger auf, um den Einfluss der antiepitaktischen Pufferschicht auf die Orientierung der *c*-Achse nicht völlig in den Hintergrund zu drängen.

Die texturierte Pufferschicht kann auch als alleinige Pufferschicht unmittelbar zwischen dem Substrat und der HTSL-Schicht angeordnet sein, insbesondere dann, wenn die *c*-Achse der HTSL-Schicht sich auch ohne antiepitaktische Pufferschicht senkrecht zur Schichtebene ausrichtet. Auch in diesem Fall ist sie jedoch vorteilhaft nicht dicker als 10 nm. Bei größeren Dicken wird die scharfe Stufenkante abgerundet, so dass die Tunnelbarriere in der HTSL-Schicht niedriger und dafür breiter wird. Dadurch wirkt sie nicht mehr als Weak-Link eines Josephson-Kontakts.

Bereits die normale Kristallstruktur der Pufferschicht kann als Texturierung ausreichen. Hierfür weist die Pufferschicht in ihrer Ebene vorteilhaft eine Gitterkonstante auf, die zwischen 90 % und 100 % der Gitterkonstante der HTSL-Schicht entlang der auszurichtenden Achse (*a* und/oder *b*) beträgt. Ein Beispiel für eine Pufferschicht, die dieses leistet, ist CeO₂. Es wächst epitaktisch auf Yttrium-stabilisiertem Zirkonoxid YSZ, das wiederum epitaktisch auf MgO wächst. Dadurch richtet sich seine Kristallorientierung in der Schichtebene senkrecht auf die Stufenkante hin aus, und es überträgt diese Orientierung auf die *a*-Achse von YBCO. Damit die Pufferschicht in dieser Weise ohne zusätzliche Texturierung wirken kann, darf die Gitterkonstante c der HTSL-Schicht kein ganzzahliges Vielfaches der Gitterkonstanten entlang der auszurichtenden Achse (*a* und/oder *b*) sein. Ansonsten kann sich statt der *a-*und/oder *b*-Achse die *c*-Achse entlang der Pufferschicht ausrichten.

Vorteilhaft umfasst die Texturierung Erhebungen und/oder Vertiefungen mit einer mittleren Höhe bzw. Tiefe zwischen 1 nm und 10 nm, bevorzugt zwischen 1 nm und 5 nm. Zu kleine Features der Texturierung wirken nicht mehr reproduzierbar auf die Ausrichtung der HTSL-Schicht in der Ebene. Bei zu großen Features können die *a*-Achse-orientierten Körner der HTSL-Schicht wachsen.

Vorteilhaft beträgt der Krümmungsradius des Substrats an der Stufenkante 10 nm oder weniger, bevorzugt 5 nm oder weniger und ganz besonders bevorzugt 1 nm oder weniger. Dann ist der Knick in der Substratoberfläche an dieser Stelle auch dann noch ein hinreichend starker Anreiz für die HTSL-Schicht, eine Korngrenze und damit das Weak-Link des Josephson-Kontakts auszubilden, wenn zwischen der HTSL-Schicht und dem Substrat eine oder mehrere Pufferschichten angeordnet sind. Der Knick ist idealerweise so scharf, dass sich in der HTSL-Schicht eine linienförmige Grenzfläche zwischen zwei Körnern ausbildet, deren Orientierungen sich in ihren *c*-Achsen voneinander unterscheiden.

In einer weiteren vorteilhaften Ausgestaltung der Erfindung trennt die Stufenkante einen planen Oberflächenbereich von einem gekrümmten Oberflächenbereich. Vorteilhaft beträgt dann der Krümmungsradius des gekrümmten Bereiches 10 nm oder mehr, bevorzugt 100 nm oder mehr und ganz besonders bevorzugt 1 µm oder mehr. Die HTSL-Schicht verläuft dann über die Stufenkante hinweg in Form einer Rutschbahn. Damit ist sichergestellt, dass die HTSL-Schicht durch die Stufenkante nur eine Korngrenze und damit nur ein Weak-Link ausbildet. Würde sie zwei oder mehr in Reihe geschaltete Weak-Links ausbilden, wäre das Bauelement nicht als Josephson-Kontakt brauchbar. Dies liegt daran, dass der Winkel θ zwischen den Kristallorientierungen der beiden Körner für mehrere in Reihe geschaltete Weak-Links in der Regel unterschiedlich sein wird. Wenn es dagegen gelingt, diesen Winkel θ für mehrere in Reihe geschaltete Weak-Links gleich zu machen, kann die Reihenschaltung aus diesen Weak-Links als effektiver Josephson-Kontakt brauchbar sein.

Dies lässt sich in einer weiteren vorteilhaften Ausgestaltung realisieren, indem die Stufe zwei plane Bereiche des Substrats mit einer ersten Orientierung trennt und gegenüber diesen planen Bereichen so geneigt ist, dass auf ihr die hochtemperatursupraleitende Funktionsschicht eine andere, aber im Bereich der Stufe konstante, Kristallorientierung des Substrats annimmt. Weiterhin muss in dieser Ausgestaltung auf eine antiepitaktische Pufferschicht verzichtet werden, damit die Ausrichtung der *c*-Achse der Funktionsschicht gerade durch das Substrat gesteuert werden kann.

Vorteilhaft ist die Oberfläche des Substrats an der Stufenkante um einen Winkel zwischen 20° und 60°, bevorzugt zwischen 30° und 50° und ganz besonders bevorzugt zwischen 35° und 45°, geknickt. Insbesondere ein Knickwinkel von 40° bewirkt einen optimalen Winkel θ zwischen den *c*-Achsen der beiden Körner der HTSL-Schicht, die an der Korngrenze zusammentreffen.

Vorteilhaft ist die Texturierung rechteckig oder linienförmig. Eine linienförmige Texturierung kann an jedem Korn die *a*- oder *b*-Achse orientieren, eine rechteckige Texturierung kann an jedem Korn beide Achsen orientieren.

Als Material für die HTSL-Schicht ist jedes Material geeignet, in dem sich die Wellenfunktion der Cooper-Paare wie beschrieben anisotrop ausbreitet und in dem eine Korngrenze eine lokale Barriere für die Ausbreitung dieser Wellenfunktion darstellt. Neben YBCO sind somit auch alle anderen oxidischen Hochtemperatursupraleiter geeignet.

Bei gegebener kritischer Stromdichte J_{c} einer HTSL-Schicht mit einer gegebenen Dicke ergibt sich der kritische Strom I_{c}, der durch eine laterale Struktur mit einer bestimmten Breite fließen kann, zu I_{c}=J_{c}*Breite*Dicke. In einem Bauelement mit definiertem I_{c} ist daher die HTSL-Schicht lateral strukturiert, beispielsweise in Form einer Brücke mit definierter Breite, die über die Stufenkante hinweg verläuft. Mit einer derartigen Brücke lässt sich ein Detektor und Generator für THz-Strahlung oder ein RF-SQUID realisieren, mit zwei Brücken auch ein DC-SQUID. Die Erfindung bezieht sich daher auch auf einen Detektor und Generator für THz-Strahlung sowie auf ein SQUID mit dem erfindungsgemäßen Bauelement. Das SQUID lässt sich mit einem Flusstransformator, beispielsweise im Sinne der deutschen Patentanmeldung 10 2009 025 716.0, zu einem hochempfindlichen Magnetometer und/oder Gradiometer erweitern.

Das hier beschriebene Grundprinzip, an der Stufenkante eine Korngrenze zu erzeugen und zu beiden Seiten der Stufenkante die Kristallorientierung der Schicht in Relation zu dieser Korngrenze auszurichten, kann ganz allgemein angewendet werden. Beispielsweise können ferromagnetische, ferroelektrische und multiferroische Eigenschaften der Tunnelbarriere zwischen kristallinen oxidischen Schichten für neuartige elektronische Bauelemente nutzbar gemacht werden.

In einer weiteren besonders vorteilhaften Ausgestaltung der Erfindung ist das Substrat texturiert, und zwischen dem Substrat und der hochtemperatursupraleitenden Funktionsschicht ist eine weitere Keimschicht aus dem Material der Funktionsschicht angeordnet. Durch die Texturierung ist auf beiden Seiten der Stufenkante die *a*- und/oder die *b*-Kristallachse in der Ebene der Keimschicht bis auf eine Abweichung von höchstens 10° senkrecht auf die Korngrenze ausgerichtet. Zugleich ist zwischen der Keimschicht und der hochtemperatursupraleitenden Funktionsschicht eine Sperrschicht angeordnet, die für mindestens ein metallisches oder halbleitendes Element des Substrats undurchlässig ist. Bezüglich der Texturierung gilt alles zuvor zur Texturierung Gesagte weiterhin.

Unter Undurchlässigkeit im Sinne dieser Ausgestaltung wird verstanden, dass das besagte Element des Substrats im Material der Sperrschicht um mindestens eine Größenordnung langsamer diffundiert als im Material der Keimschicht bzw. Funktionsschicht.

Es ist bekannt (Hao et al., "Microstructure and magnesium diffusion in YBa2Cu3O7-δ d films on bicrystal MgO substrates", Journal of Applied Physics 91 (11), 9251-9254 (2002)), dass bestimmte metallische oder halbleitende Elemente aus Substraten die Qualität einer auf solchen Substraten aufgewachsenen Funktionsschicht verschlechtern können, indem sie mit dem Material der Funktionsschicht reagieren und/oder Defekte in die Funktionsschicht einbringen. Als Beispiele für solche störenden Elemente sind insbesondere Magnesium, Aluminium und Silizium zu nennen. Gerade die Oxide des Magnesiums, Aluminium und Siliziums sind aber wegen ihrer passenden Gitterkonstante, kleinen Dielektrizitätskonstante und niedrigen Preise bevorzugte Substrate für das Aufwachsen von beispielsweise YBCO als Hochtemperatursupraleiter. Durch die Sperrschicht kann nun der Nachteil, dass derartige Substrate die Funktionsschicht kontaminieren, überwunden werden.

Würde nun, wie von Hao et al. vorgeschlagen, die Sperrschicht unmittelbar auf das Substrat aufgebracht, würde sich ihre Kristallstruktur nach der Kristallstruktur des Substrats richten und nicht nach dessen Texturierung; es fände keine Graphoepitaxie statt. Damit wäre die erfindungsgemäße Ausrichtung der kristallographischen Orientierung in der Funktionsschicht zu beiden Seiten der Stufenkante verloren. Aus diesem Grund ist die Keimschicht vorgesehen, die entweder unmittelbar oder vermittelt durch eine antiepitaktische Pufferschicht auf dem Substrat aufgebracht sein kann. Völlig analog zur Funktionsschicht in einem erfindungsgemäßen Bauelement ohne Sperrschicht und Keimschicht wird die Orientierung der Keimschicht durch Graphoepitaxie zu beiden Seiten der Stufenkante ausgerichtet, so dass an der Stufenkante eine Korngrenze entsteht. Die auf diese Weise festgelegte Orientierung wird von der Sperrschicht übernommen und an die Funktionsschicht weitergegeben. Letztendlich ist damit die Funktionsschicht nach wie vor indirekt durch die Texturierung des Substrats ausgerichtet. Zugleich ist sie aber durch die Sperrschicht vor dem Eindringen metallischer oder halbleitender Kontaminanten aus dem Substrat geschützt.

Vorteilhaft ist die Keimschicht normalleitend ausgebildet. Darunter wird im Sinne dieser Ausgestaltung verstanden, dass ihre supraleitenden Eigenschaften um mindestens eine Größenordnung schlechter sind als die der Funktionsschicht. Da die Keimschicht aus dem gleichen Material besteht wie die Funktionsschicht, könnte sie im Prinzip ebenfalls hochtemperatursupraleitend sein. In dieser Ausgestaltung ist jedoch die Hochtemperatursupraleitung in der Keimschicht bewusst unterdrückt, damit die Keimschicht keinen zur Funktionsschicht konkurrierenden Pfad für einen Suprastrom bildet. Ein solcher konkurrierender Pfad könnte Rauschen verursachen und die Funktion des Bauelements stören. Die Supraleitung kann beispielsweise unterdrückt werden, indem die Keimschicht sehr dünn ausgestaltet ist. Sie wird dann vollständig mit Metall bzw. Halbleiter aus dem Substrat kontaminiert; es gibt in der Keimschicht keinen nicht kontaminierten Pfad mehr, entlang dessen noch ein Suprastrom fließen könnte. Daher weist die Keimschicht vorteilhaft eine Dicke von höchstens 50 nm, bevorzugt zwischen 5 und 20 nm und/oder höchstens 1/3 der Dicke der Funktionsschicht, auf. Eine Dicke von 10 nm hat sich in den Versuchen der Erfinder als optimal erwiesen.

Vorteilhaft weist die Sperrschicht eine Dicke zwischen 1 nm 1 µm, bevorzugt zwischen 10 und 100 nm und ganz besonders bevorzugt zwischen 20 und 40 nm, auf. Die untere Grenze von 1 nm rührt daher, dass 1 nm die typische Stufenhöhe von Keimschichten aus hochtemperatursupraleitenden Materialien wie YBCO ist und eine vollständige Bedeckung aller Stufen notwendig ist, damit die Diffusion metallischer oder halbleitender Kontaminanten aus dem Substrat über die Keimschicht in die Funktionsschicht unterbunden werden kann. Die obere Grenze von 1 µm rührt daher, dass die Sperrschicht einen anderen thermischen Ausdehnungskoeffizienten aufweist als die Funktionsschicht und/oder das Substrat. Die Schichten müssen jeweils bei hoher Temperatur aufgewachsen werden. Je dicker die Sperrschicht ist, desto größer ist die Gefahr, dass die mechanischen Spannungen zwischen der Sperrschicht und den übrigen Schichten zu einem Zerreißen des Schichtstapels führen. Des weiteren ist es wünschenswert, wenn mit der Sperrschicht möglichst wenige Fehlstellen in den Schichtstapel eingebracht werden und die Herstellung der Sperrschicht nicht unverhältnismäßig viel Zeit beansprucht. Die Sperrschicht wächst typischerweise nur mit etwa 30 nm pro Stunde. Eine Sperrschicht von 30 nm Dicke bedeckt zuverlässig die darunterliegende Korngrenze der Keimschicht und stellt damit sicher, dass sich entlang dieser Korngrenze kein Pfad bildet, entlang dessen metallische oder halbleitende Kontaminanten aus dem Substrat in die Funktionsschicht diffundieren können.

Vorteilhaft weist die Sperrschicht eine Perowskitstruktur auf. Indem die meisten hochtemperatursupraleitenden Funktionsschichten, insbesondere YBCO, ebenfalls eine Perowskitstruktur aufweisen, ist dann eine optimale Übertragung der von der Keimschicht graphoepitaktisch übernommenen kristallographischen Ausrichtung in die Funktionsschicht gewährleistet. Als Materialien für die Sperrschicht sind insbesondere SrTiO₃, LaAlO₃ und NdGaO₃ geeignet.

Im Rahmen der Erfindung wurde auch ein Verfahren zur Herstellung eines Bauelements mit einem Josephson-Kontakt aus einem Substrat mit mindestens einer Stufenkante in seiner Oberfläche entwickelt. Dabei wird eine hochtemperatursupraleitende Schicht (Funktionsschicht) auf die Oberfläche aufgebracht, so dass sie sich zu beiden Seiten der Stufenkante erstreckt. Dieses Verfahren eignet sich besonders zur Herstellung erfindungsgemäßer Bauelemente. Die für das erfindungsgemäße Bauelement gegebene Offenbarung gilt daher mutatis mutandis ausdrücklich auch für dieses Verfahren..

Erfindungsgemäß wird das Substrat texturiert und/oder es wird eine texturierte Pufferschicht auf das Substrat aufgebracht. Anschließend wird die hochtemperatursupraleitende Schicht (Funktionsschicht) im Wege der Graphoepitaxie aufgebracht, so dass sie an der Stufenkante eine Korngrenze ausbildet und ihre *a*- und/oder *b*-Achse durch die Texturierung bis auf eine Abweichung von höchstens 10° senkrecht auf die Korngrenze ausgerichtet wird.

Es wurde erkannt, dass gerade durch die Graphoepitaxie ein Schichtwachstum erzielt werden kann, bei dem die *a*- und/oder *b*-Achse homogen senkrecht auf die Korngrenze ausgerichtet ist. Die Graphoepitaxie beginnt damit, dass sich zunächst Inseln, deren Orientierung oft unabhängig von der Kristallstruktur des Substrats ist, auf Kanten und Ecken der Texturierung bilden. Die Texturierung bewirkt so, dass diese Inseln unabhängig davon, wo sie sich in welcher Reihenfolge bilden, einheitlich orientiert werden. Wenn die Inseln zu einer Schicht vervollständigt werden, bildet sich aus der Nahordnung der einzelnen Inseln eine Fernordnung der Schicht. Diese kollektive Fernordnung erfasst auch anfänglich falsch oder gar nicht orientiert aufgewachsene Inseln.

Beim Wachstum von YBCO und anderen oxidischen Hochtemperatursupraleitern (HTSL) mit geschichteter Kristallstruktur begünstigen die Wachstumskinetik und die energetischen Verhältnisse an der Oberfläche die Bildung von Inseln (Plättchen) mit (100), (010) und (001) orientierten Oberflächen. Die [100]- und [010]-Achsen dieser Inseln richten sich an Kanten, Erhebungen oder Vertiefungen der Oberfläche, auf die der HTSL aufgebracht wird, aus. Wird eine Texturierung mit senkrecht auf die Stufenkante orientierten derartigen Features in das Substrat oder in eine zwischen Substrat und HTSL aufgebrachte Pufferschicht eingebracht, können zunächst die Inseln und später die *a*- und/oder *b*-Achse der ganzen Schicht auf die Stufenkante und damit auf die Korngrenze hin orientiert werden.

Beispielsweise kann YBCO auf MgO oder YSZ aufgebracht werden. Die Gitterfehlanpassung von YBCO zu MgO bzw. YSZ beträgt 9 % bzw. 4 %. Je größer die Gitterfehlanpassung ist, desto größer wird die Oberflächenenergie der aufwachsenden HTSL-Schicht. Dadurch steigt auch die potentielle Energie, die diejenigen Oberflächenkonfigurationen, die nicht dem energetischen Minimum entsprechen, gegenüber diesem Minimum haben. Diese potentielle Energie wiederum ist eine treibende Kraft für die Umorientierung. Somit wird es bei größerer Gitterfehlanpassung schwieriger, einkristallines Wachstum zu erzielen, aber es wird einfacher, mittels Graphoepitaxie aufzuwachsen.

Für die Herstellung erfindungsgemäßer Bauelemente entsprechend der Ausgestaltung mit Keimschicht und Sperrschicht wurde ein alternatives Verfahren entwickelt, das durch eine andere Abfolge von Verfahrensschritten gekennzeichnet ist. Zu Beginn dieses Verfahrens wird das Substrat texturiert. Anschließend wird eine Keimschicht aus dem Material der Funktionsschicht im Wege der Graphoepitaxie aufgebracht, so dass die Keimschicht an der Stufenkante eine Korngrenze ausbildet und ihre *a*- und/oder *b*-Achse durch die Texturierung bis auf eine Abweichung von höchstens 10° senkrecht auf die Korngrenze ausgerichtet wird. Damit erhält die Keimschicht bereits genau diejenige kristallographische Orientierung, die am Ende die Funktionsschicht erhalten soll.

Indem anschließend eine Sperrschicht, die für mindestens ein metallisches oder halbleitendes Element des Substrats undurchlässig ist, epitaktisch zur Keimschicht aufgebracht wird, wird die kristallographische Orientierung der Keimschicht in die Sperrschicht übertragen. Indem anschließend die hochtemperatursupraleitende Funktionsschicht wiederum epitaktisch zur Sperrschicht aufgebracht wird, wird die gleiche kristallographische Orientierung in die letztendliche Funktionsschicht übertragen.

Im Ergebnis bildet somit auch die Funktionsschicht an der Stufenkante eine Korngrenze aus, und ihre *a*- und/oder *b*-Achse ist bis auf eine Abweichung von höchstens 10° senkrecht auf die Korngrenze ausgerechnet. Die Quelle für diese Ausrichtung ist letzten Endes die Texturierung des Substrats; die Ausrichtung wird jedoch vermittelt durch die Keimschicht und die Sperrschicht.

In einer besonders vorteilhaften Ausgestaltung der Erfindung wird die Orientierung der *c-*Achse der hochtemperatursupraleitenden Schicht (Funktionsschicht) oder der Keimschicht von der Orientierung des Substrats entkoppelt, indem vor dem Aufbringen der hochtemperatursupraleitenden Schicht (Funktionsschicht) oder der Keimschicht eine antiepitaktische Pufferschicht aufgebracht wird, die entweder amorph ist oder eine nicht zum Substrat und/oder zur hochtemperatursupraleitenden Schicht (Funktionsschicht) bzw. der Keimschicht epitaxiekompatible Kristallstruktur aufweist. Dabei kann die antiepitaktische Pufferschicht selbst texturiert werden. Sie kann aber auch zwischen Substrat und texturierter Pufferschicht oder zwischen texturierter Pufferschicht und HTSL-Schicht (Funktionsschicht) bzw. Keimschicht aufgebracht werden. Wird die *c*-Achse der HTSL-Schicht (Funktionsschicht) bzw. der Keimschicht von der Orientierung des Substrats entkoppelt, richtet sich ihre Orientierung allein nach den energetischen Verhältnissen der HTSL-Schicht bzw. der Keimschicht selbst. Dementsprechend ist eine Orientierung der *c*-Achse senkrecht zur Schichtebene bevorzugt.

Eine Alternative ist, auf die antiepitaktische Pufferschicht zu verzichten aber die Texturierung bzw. texturierte Schicht und gegebenenfalls die Sperrschicht weiterhin benutzen. Ohne antiepitaktische Pufferschicht richtet sich die *c*-Achse der HTSL-Schicht (Funktionsschicht) bzw. der Keimschicht nach der Kristallstruktur des Substrats. Im Beispiel eines MgO Substrats mit YBCO als HTSL-Schicht (Funktionsschicht) bzw. Keimschicht gibt es zwei bevorzugte Orientierungen der *c*-Achse: 0 Grad ("cube-on-cube") und 45 Grad. Verläuft die Stufe in einem steileren Winkel als 19 Grad zu den planen Bereichen des Substrats, wird im Bereich der Stufe 45 Grad Orientierung und in den planen Bereichen 0 Grad Orientierung gebildet. Dementsprechend bilden sich jeweils an den Übergängen der Stufe zwischen den planen Bereichen Korngrenzen, an denen sich die Kristallorientierung der Funktionsschicht jeweils um einen Winkel θ= 45 Grad ändert. Eine Sperrschicht über der Keimschicht ist auch in diesem Fall weiterhin wünschenswert, um Kontaminierung der HTSL-Schicht (Funktionsschicht) zu reduzieren bzw. zu vermeiden. Der in dieser Ausgestaltung entstehende Josephson-Kontakt mit zwei Korngrenzen (Weak-Links) mit jeweils θ=45 Grad Winkeländerung der Kristallorientierung weist weniger mechanische Spannungen und Kleinwinkel-Korngrenzen auf und kann damit vorteilhaft ein geringeres Eigenrauschen im Vergleich zu den aus nur einer Korngrenze gebildeten Josephson-Kontakten bieten. Hierzu sollte die Stufe vorteilhaft nicht gekrümmt (rutschbahnförmig) verlaufen, sondern an ihrem oberen und unteren Übergang zu den planen Bereichen des Substrats jeweils eine Kante aufweisen. Dies betrifft auch die Herstellung von Detektoren und Generatoren von THz-Strahlung sowie Herstellung von SQUIDs auf der Basis von solchen Josephson-Kontakten.

Für die Herstellung einer Kante gibt es zwei verschiedene Methoden. Es wird jeweils trockengeätzt und eine in Teilbereichen des Substrats aufgebrachte Fotoresist-Schicht als Maske benutzt.

Bei der ersten Methode wird der Ionenstrahl für das Trockenätzen in den zwischen Substrat und Kante der Fotoresist- Schicht eingeschlossenen Winkel eingestrahlt. Dann wird der Winkel der Stufenkante durch die Ätzzeit bestimmt. Diese Methode ist insbesondere vorteilhaft, wenn eine scharfe Kante am oberen Rand der Stufe entstehen und die Stufe ansonsten rutschbahnförmig abgerundet verlaufen soll.

Bei der zweiten Methode wird der Ionenstrahl für das Trockenätzen über die obere Kante der Fotoresist-Schicht hinweg auf die Substratoberfläche eingestrahlt. Der Winkel der Stufenkante wird dann durch den Winkel bestimmt, den der Ionenstrahl mit der Substratoberfläche einschließt. Dadurch wird der Winkel besser kontrollierbar. Diese Methode ist vorteilhaft, wenn zwei Korngrenzen mit gleichem Winkel θ zwischen den Kristallorientierungen erzeugt werden sollen.

### Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:
- Figur 1:: Ausführungsbeispiel des erfindungsgemäßen Bauelements mit zwei Pufferschichten.
- Figur 2:: Ausführungsbeispiel des erfindungsgemäßen Bauelements mit nur einer Pufferschicht.
- Figur 3:: AFM-Aufnahme eines texturierten Substrats.
- Figur 4:: AFM-Aufnahme einer YBCO-Schicht auf einer antiepitaktischen Pufferschicht aus MgCO₃, die wiederum auf ein texturiertes MgO-Substrat aufgebracht wurde.
- Figur 5:: Elektronenmikroskopische Aufnahme einer YBCO-Schicht, die auf einer zu dicken antiepitaktischen Pufferschicht aufgewachsen wurde.
- Figur 6:: Elektronenmikroskopische Aufnahme einer YBCO-Schicht, die auf einer gegenüber Figur 5 dünneren antiepitaktischen Pufferschicht aufgewachsen wurde.
- Figur 7:: Ausführungsbeispiel des erfindungsgemäßen Bauelements mit Sperrschicht und Keimschicht in Schemazeichnung.
- Figur 8:: Elektronenmikroskopische Querschnittaufnahmen des in Figur 7 skizzierten Ausführungsbeispiels.
- Figur 9:: Elektronenmikroskopische Aufsichten auf die Funktionsschichten zweier erfindungsgemäßer Bauelemente ohne (a) und mit (b) Sperrschicht und Keimschicht.
- Figur 10:: Elektronenmikroskopische Aufnahme einer YBCO-Schicht, die mit Texturierung und YBCO-Keimschicht und SrTiO₃-Sperrschicht, aber ohne antiepitaktische Pufferschicht auf der 45-Grad Stufe eines MgO-Substrats aufgewachsen wurde.

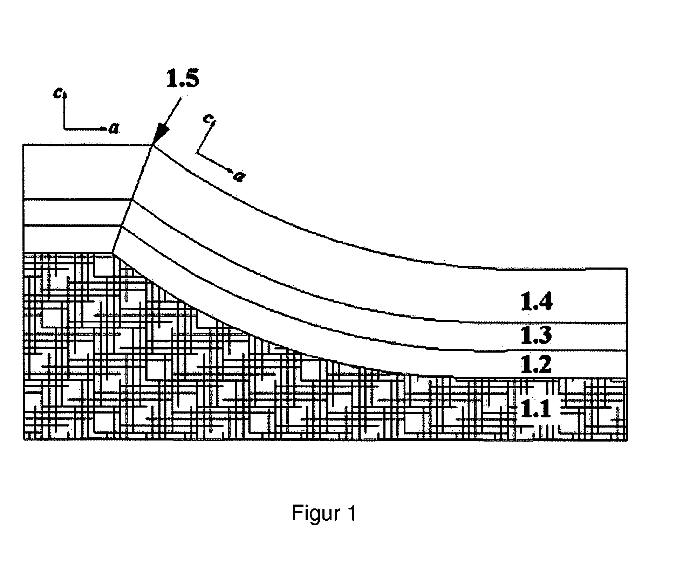

Figur 1 zeigt ein Ausführungsbeispiel des erfindungsgemäßen Bauelements. Auf dem Substrat 1.1 aus MgO mit einer durch Ionenstrahl-Ätzung gereinigten Oberfläche befindet sich eine texturierte, etwa 10 nm dicke, homoepitaktische MgO Pufferschicht 1.2. Durch die Reinigung des Substrats wurde eine amorphe Schicht von dessen Oberfläche entfernt; dies ermöglicht das homoepitaktische Wachstum. Durch die raue Inselstruktur der Pufferschicht 1.2 ist automatisch eine Texturierung vorgegeben. Auf der homoepitaktischen Pufferschicht 1.2 befindet sich eine etwa 0,5 nm dicke antiepitaktische Pufferschicht 1.3 aus MgCO₃. Diese entkoppelt die Orientierung der *c*-Achse der darauf aufgebrachten etwa 150 nm dicken YBCO-Schicht (Funktionsschicht) 1.4 vom Einfluss des Substrats 1.1. Die *c*-Achse ist daher überall senkrecht auf der Oberfläche der YBCO-Schicht 1.4. Zugleich sind die *a*- und *b-*Achsen an der rechteckigen Insel-Struktur (Texturierung) der homoepitaktischen MgO Schicht orientiert. Die amorphe MgCO₃-Pufferschicht kann mit unterschiedlichen Depositionsmethoden hergestellt werden. Beispielsweise kann das MgCO₃ mit einer kurzen chemischen Reaktion des MgO in einem CO₂-Plasma oder in organischen Flüssigkeiten wie, zum Beispiel, Aceton gebildet werden. Es kann aber auch natürlicherweise durch eine Exposition der MgO-Oberfläche an Luft aufwachsen. An Stelle von MgCO₃ kann auch eine 0,5 nm bis 1 nm dicke CeO₂-Schicht als antiepitaktische Pufferschicht verwendet werden.

Das Substrat 1.1 weist eine scharfe Stufenkante auf. Diese veranlasst die YBCO-Schicht 1.4, eine Korngrenze 1.5 auszubilden. Diese bildet das Weak-Link für den Josephson-Kontakt. Die Stufenkante trennt einen planen Oberflächenbereich des Substrats 1.1 von einem gekrümmt verlaufenden Bereich, der wiederum stetig in einen weiteren planen Bereich übergeht. Dabei ist der Krümmungsradius jeweils hinreichend weit, so dass die YBCO-Schicht (Funktionsschicht) 1.4 keine weitere Korngrenze ausbildet.

Die Texturierung der Pufferschicht 1.2 hat eine Vorzugsrichtung senkrecht zur Stufenkante des Substrats 1.1. Dementsprechend ist die *a*- und/oder *b*-Achsen der YBCO-Schicht 1.4 zu beiden Seiten der Stufenkante jeweils senkrecht zur Korngrenze 1.5 orientiert. Damit kann ein maximaler Suprastrom I_{c} mit maximalen Widerstand Rₙ im normalleitenden Zustand durch die Korngrenze 1.5 transportiert werden.

Die laterale Strukturierung der YBCO-Schicht 1.4 in der Schichtebene, die aus der Schicht das konkrete Bauelement formt, ist in Figur 1 nicht eingezeichnet.

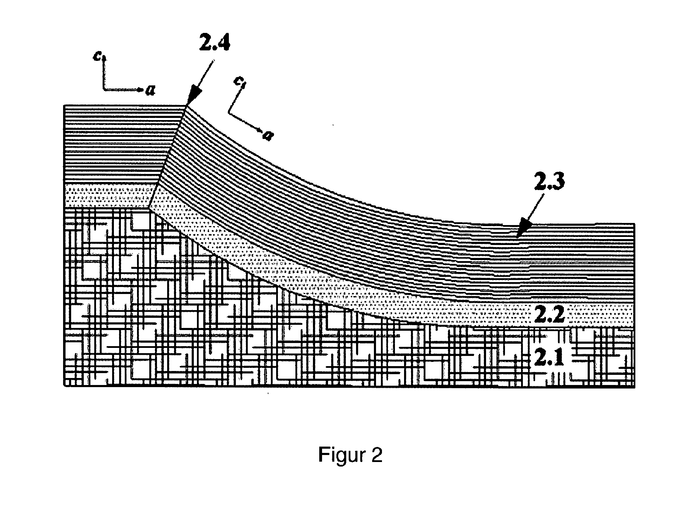

Figur 2 zeigt ein weiteres Ausführungsbeispiel des erfindungsgemäßen Bauelements. Auf dem Substrat 2.1 ist eine antiepitaktische Schicht 2.2 aufgebracht, die gleichzeitig texturiert ist. Sie entkoppelt somit die Orientierung der *c*-Achse der darauf aufgebrachten YBCO-Schicht (Funktionsschicht) 2.3 vom Einfluss des Substrats 2.1, während ihre Texturierung zugleich die *a*-Achse der YBCO-Schicht 2.3 in Richtung der Korngrenze 2.4 orientiert. Ursache für die Korngrenze 2.4 ist die Stufenkante im Substrat 2.1. Die laterale Strukturierung der YBCO-Schicht (Funktionsschicht) 2.3 in der Schichtebene, die aus der Schicht das konkrete Bauelement formt, ist in Figur 2 nicht eingezeichnet.

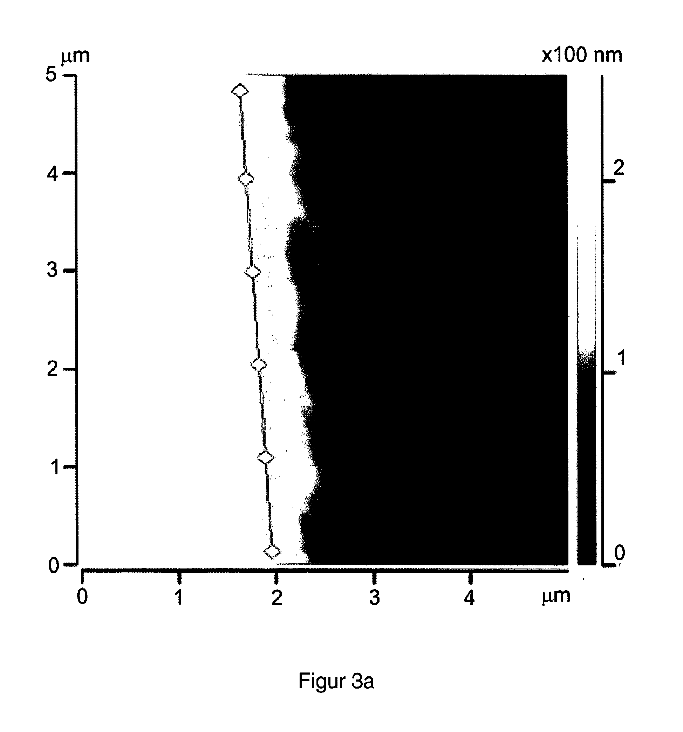

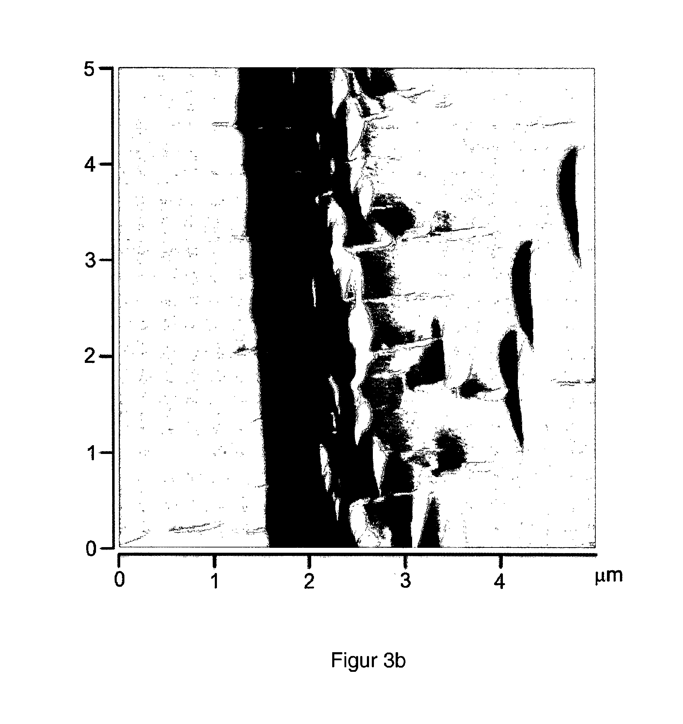

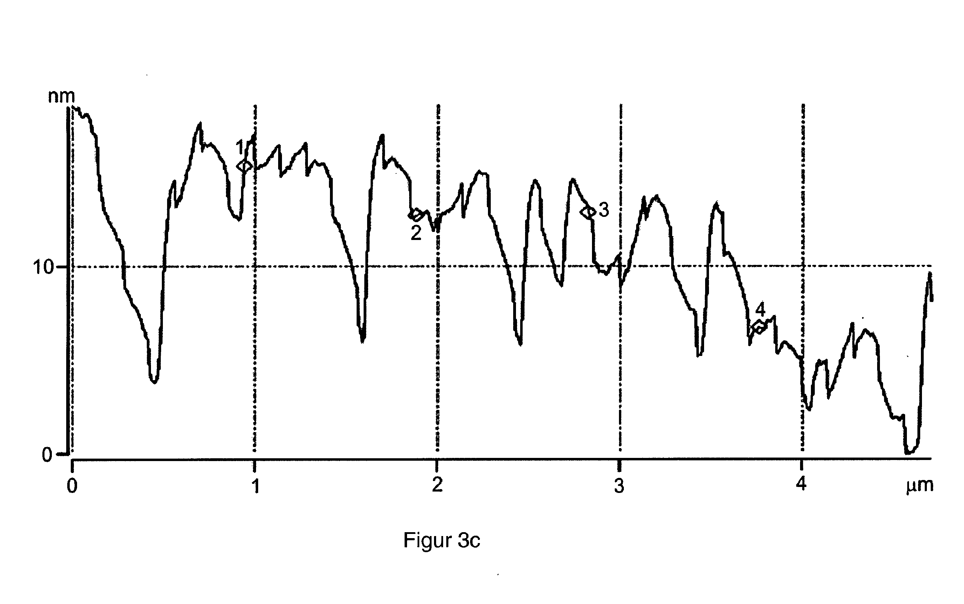

Figur 3 zeigt eine AFM-Aufnahme eines texturierten Substrats. Teilbild a ist die topographische Aufnahme, Teilbild b zeigt das das Phasensignal, in dem topographische Features nicht höhentreu, aber dafür verdeutlicht hervortreten. Teilbild c ist ein Linescan, der in unmittelbarer Nähe zur Stufenkante aus der topographischen Aufnahme entnommen wurde.

Im Linescan in Bild 3c sind vier Punkte 1 bis 4 markiert. Die folgende Tabelle gibt oberhalb der Diagonalen die laterale Entfernung von einem Punkt zu den anderen Punkten und unterhalb der Diagonalen den Höhenunterschied von einem Punkt zu den anderen Punkten an:

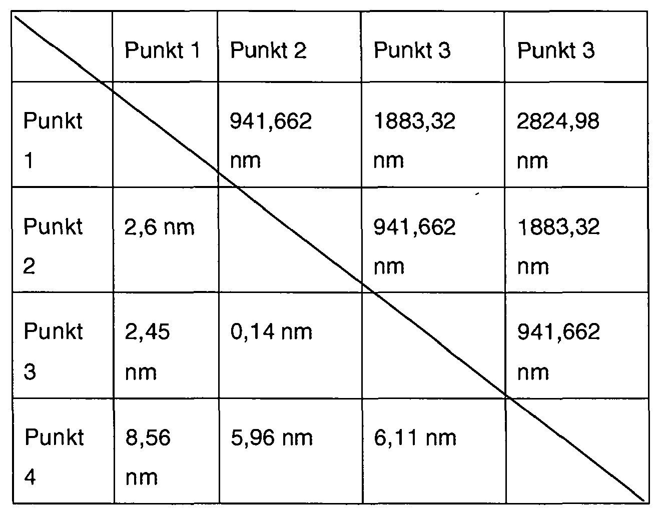

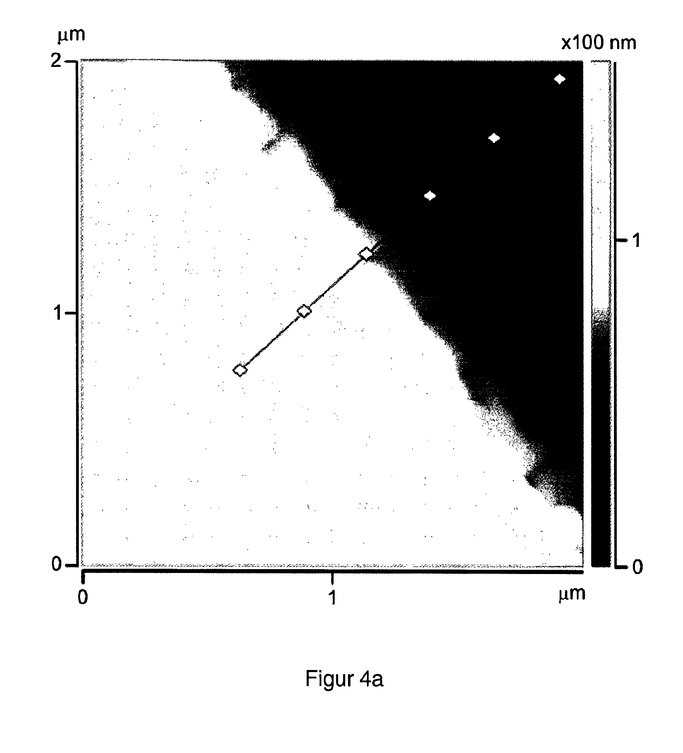

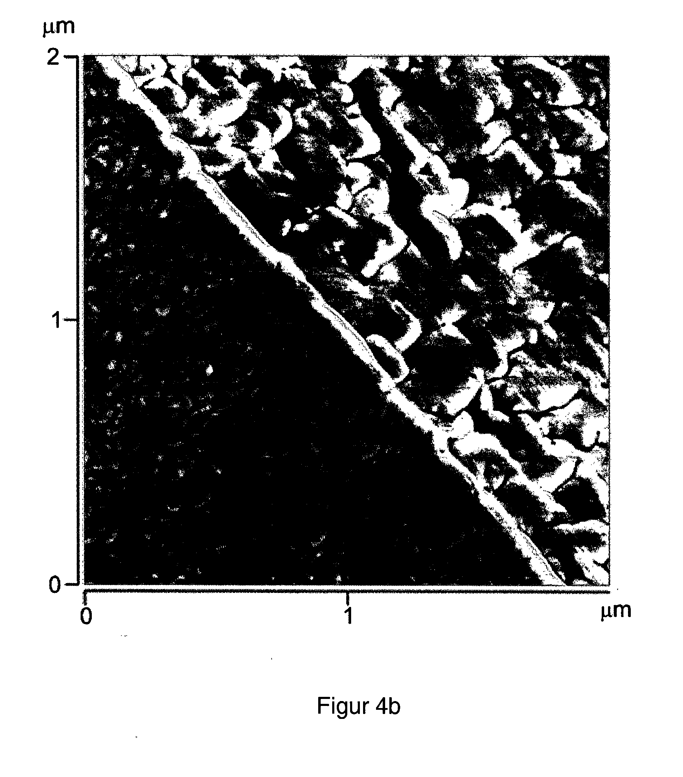

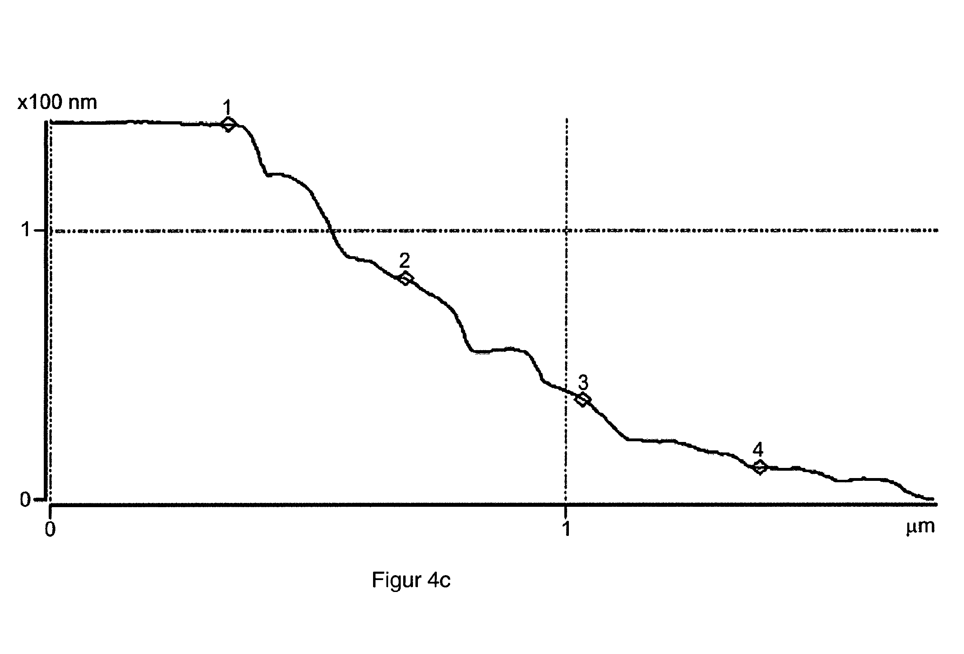

Figur 4 zeigt eine AFM-Aufnahme einer YBCO-Schicht (Funktionsschicht), die auf einer antiepitaktischen Pufferschicht aus MgCO₃ aufgewachsen wurde, welche wiederum auf einem texturierten MgO-Substrat aufgewachsen wurde. Aus dieser Schicht kann durch geeignete laterale Strukturierung, die einen Josephson-Kontakt mit definierten Dimensionen und damit auch definiertem I_{c} schafft, ein Bauelement mit einem Josephson-Kontakt gefertigt werden. Teilbild a zeigt die topographische Aufnahme, Teilbild b zeigt das Phasensignal. Teilbild c ist ein der topographischen Aufnahme entnommener Linescan. Die Stufenkante verläuft in den Teilbildern a und b diagonal von links oben nach rechts unten.

Das Phasenbild b zeigt deutlich, dass die Kristallstruktur des YBCO sich an der Stufenkante stark ändert. Auf dem oberen Plateau der Stufenkante links unten im Bild ist das YBCO in annähernd rechteckig begrenzten Spiralstrukturen aufgewachsen, wobei eine Seite des Rechtecks jeweils senkrecht auf die Stufenkante und damit auf die Korngrenze zwischen den beiden verschiedenen Kristallorientierungen ausgerichtet ist. Jenseits der Stufenkante, rechts oben im Bild, ist das YBCO in einer raueren Struktur aus rechteckig begrenzten Inseln aufgewachsen, bei denen eine Seite wiederum rechtwinklig auf die Stufenkante ausgerichtet ist.

Im Linescan in Bild 4c sind vier Punkte 1 bis 4 markiert. Die folgende Tabelle gibt oberhalb der Diagonalen die laterale Entfernung von einem Punkt zu den anderen Punkten und unterhalb der Diagonalen den Höhenunterschied von einem Punkt zu den anderen Punkten an:

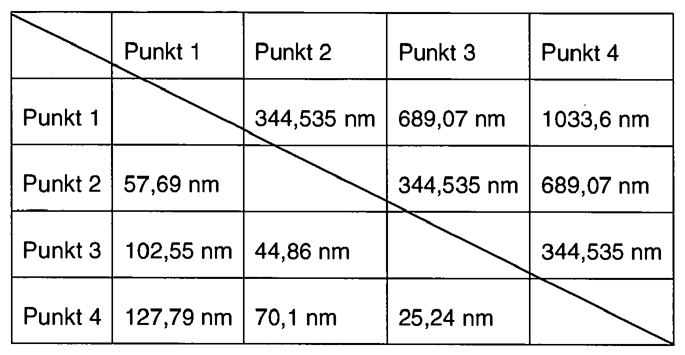

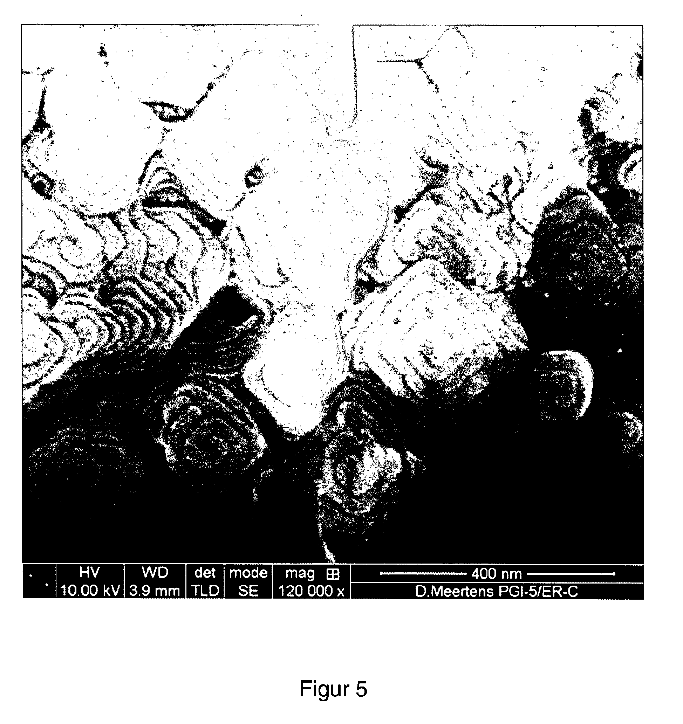

Figur 5 ist eine rasterelektronenmikroskopische Aufnahme eines fehlgeschlagenen Versuchs, ein erfindungsgemäßes Bauelement herzustellen. Die Aufnahme zeigt die Oberfläche einer YBCO-Schicht, die auf einer etwa 10 nm dicken antiepitaktischen Pufferschicht aus MgCO₃ aufgewachsen und noch nicht lateral strukturiert wurde. Diese antiepitaktische Pufferschicht war wiederum auf einem texturierten MgO Substrat mit einer Stufenkante aufgewachsen worden. Die Stufenkante verläuft in der Bildmitte senkrecht von oben nach unten.

Das YBCO ist in Form von terrassenähnlichen Körnern mit annähernd rechteckiger Grundfläche aufgewachsen. Die Körner wachsen entlang der *c*-Achse des YBCO in die Höhe. Diese Achse steht offensichtlich senkrecht auf der Zeichenebene, so dass die antiepitaktische Pufferschicht die Orientierung der *c*-Achse erfolgreich vom Einfluss des Substrats entkoppelt hat, das bestrebt ist, die *c*-Achse in die Schichtebene zu drehen. Die Kanten der Grundfläche eines jeden Korns sind die *a*- und *b*-Kristallachsen des YBCO. Bei fast allen sichtbaren Körnern bilden die *a*- und *b*-Kristallachsen einen Winkel von 45° mit der Stufenkante. Dies ist gerade der Winkel, bei dem nur ein minimaler Suprastrom zwischen den beiden Elektroden des Josephson-Kontakts zu beiden Seiten der Stufenkante transportiert werden kann. Der Erfinder führt dies darauf zurück, dass die antiepitaktische Pufferschicht zu dick war. Sie hat nicht nur die Orientierung der *c*-Achse der YBCO-Schicht vom Substrat entkoppelt, sondern die YBCO-Schicht auch so stark von der in das Substrat eingebrachten Texturierung abgeschirmt, dass diese die *a*- und *b*-Achsen des YBCO nicht mehr orientieren konnte.

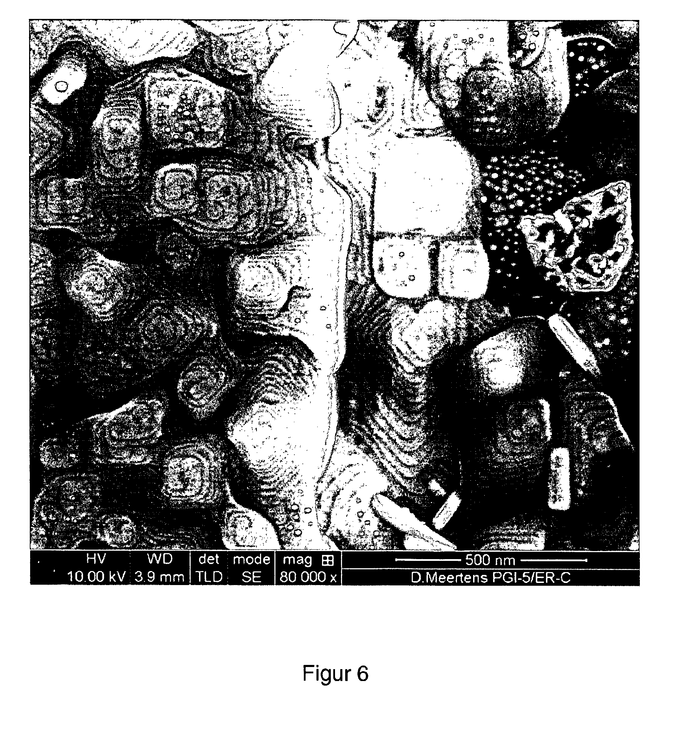

Figur 6 zeigt einen gleichwertigen Ausschnitt aus einer erfolgreich hergestellten erfindungsgemäßen YBCO-Schicht (Funktionsschicht) vor der lateralen Strukturierung zum konkreten Bauelement. Gegenüber Figur 5 wurde die Dicke der antiepitaktischen Pufferschicht auf 0,5 nm reduziert. Dies hat bewirkt, dass nunmehr die *a*-Achse der weitaus meisten Körner senkrecht auf der in der Bildmitte von oben nach unten verlaufenden Stufenkante steht. Dadurch kann ein maximaler Suprastrom über die Stufenkante und damit auch über den Josephson-Kontakt transportiert werden. Zugleich hat die antiepitaktische Pufferschicht nach wie vor die Orientierung der *c*-Achse vom Einfluss des Substrats entkoppelt. Die Orientierung der *c-*Achse ist gegenüber Figur 5 unverändert.

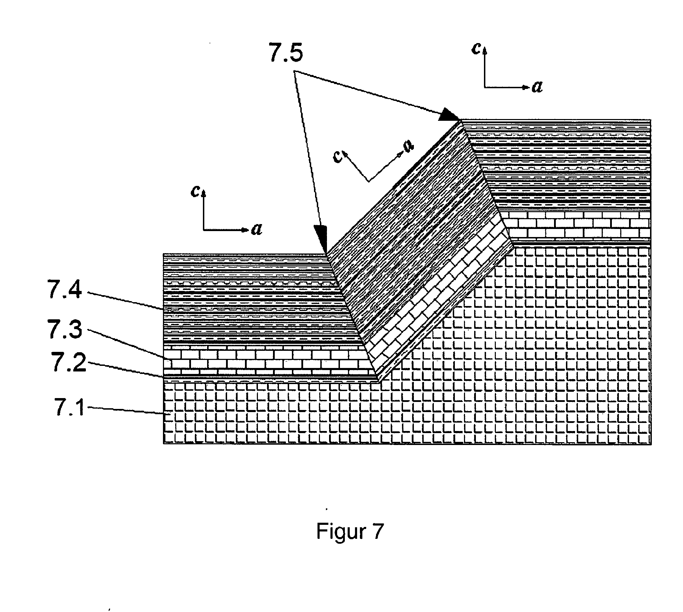

Figur 7 zeigt schematisch ein Ausführungsbeispiel des erfindungsgemäßen Bauelements mit Sperrschicht und Keimschicht. Auf dem texturierten MgO-Substrat 7.1 ist zunächst eine 10 nm dicke YBCO-Keimschicht 7.2 aufgebracht, deren kristallographische Orientierung durch Graphoepitaxie an der Texturierung des Substrats 7.1 bereits in der gleichen Weise ausgerichtet ist wie dies für die spätere Funktionsschicht 7.4 gewünscht ist. Auf die Keimschicht 7.2 ist eine 30 nm dicke SrTiO₃ (STO)-Sperrschicht 7.3 epitaktisch aufgewachsen, die die Orientierung der Keimschicht 7.2 übernimmt. Die hierauf aufgewachsene Funktionsschicht 7.4 übernimmt wiederum die Orientierung der Sperrschicht 7.3 und damit die Orientierung der Keimschicht 7.2. Somit ist die Funktionsschicht 7.4 genauso ausgerichtet, als wäre sie unmittelbar auf dem Substrat 7.1 aufgewachsen worden. Indem die Keimschicht 7.2 beim Aufwachsen auf das Substrat 7.1 an beiden Stufenkanten des Substrats jeweils eine Korngrenze ausgebildet hat, hat sich an dieser Stelle in der Sperrschicht 7.3 und schließlich auch in der Funktionsschicht 7.4 jeweils eine Korngrenze 7.5 ausgebildet. Zugleich ist die Funktionsschicht 7.4 durch die Sperrschicht 7.3 vor dem Eindringen von Magnesium aus dem Substrat 7.1 geschützt.

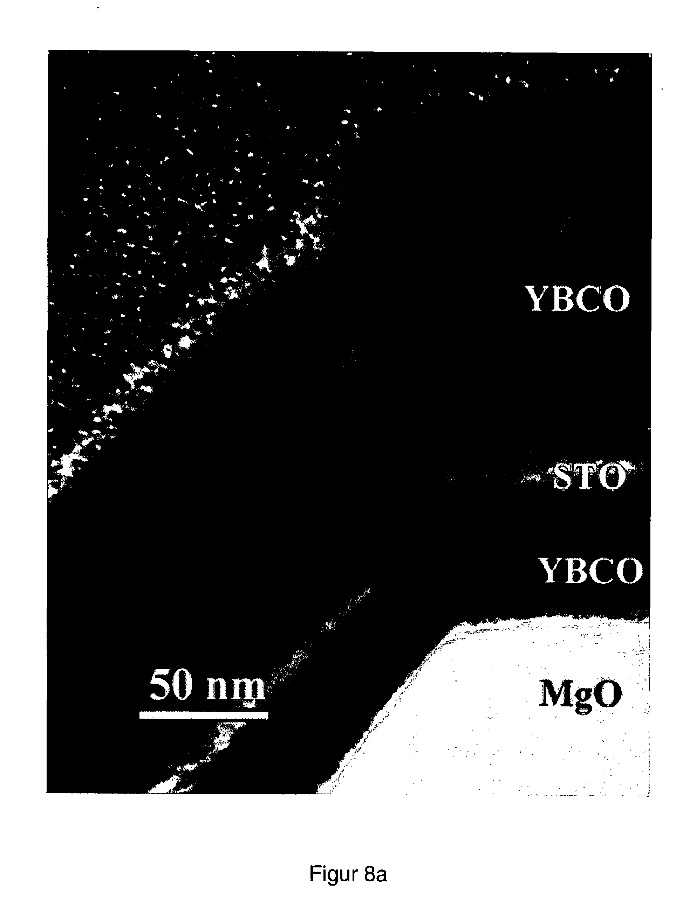

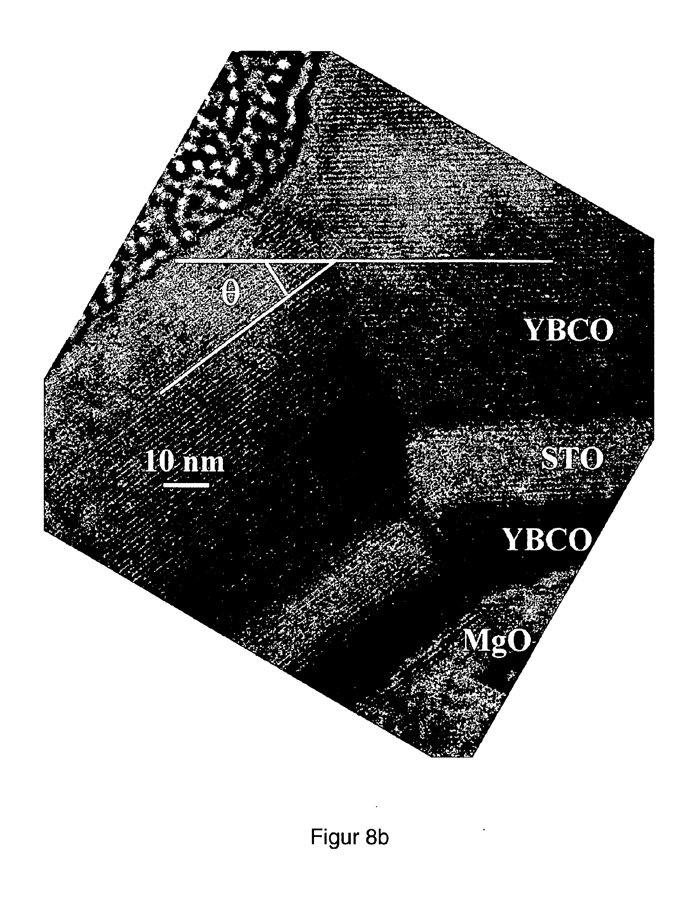

Figur 8 zeigt transmissionselektronenmikroskopische Querschnittaufnahmen des in Figur 7 skizzierten Ausführungsbeispiels in zwei verschiedenen Vergrößerungsstufen (Teilbilder a und b). Dargestellt ist nur der Bereich um die rechte der in Figur 7 gezeigten Stufenkanten im Substrat 7.1. Der in Figur 8b eingezeichnete Winkel θ verdeutlicht die Verkippung der Kristallorientierung an der Korngrenze, die durch die Stufe im Substrat bewirkt wird und durch alle Schichten des Schichtstapels reicht. Die SrTiO₃ (STO)-Sperrschicht zeigt an der Korngrenze lokal eine Einschnürung. Sie könnte also nicht wesentlich dünner gemacht werden, ohne dass an der Korngrenze möglicherweise ein Pfad entsteht, entlang dessen Magnesium in die über der STO-Schicht liegende YBCO-Funktionsschicht diffundieren könnte.

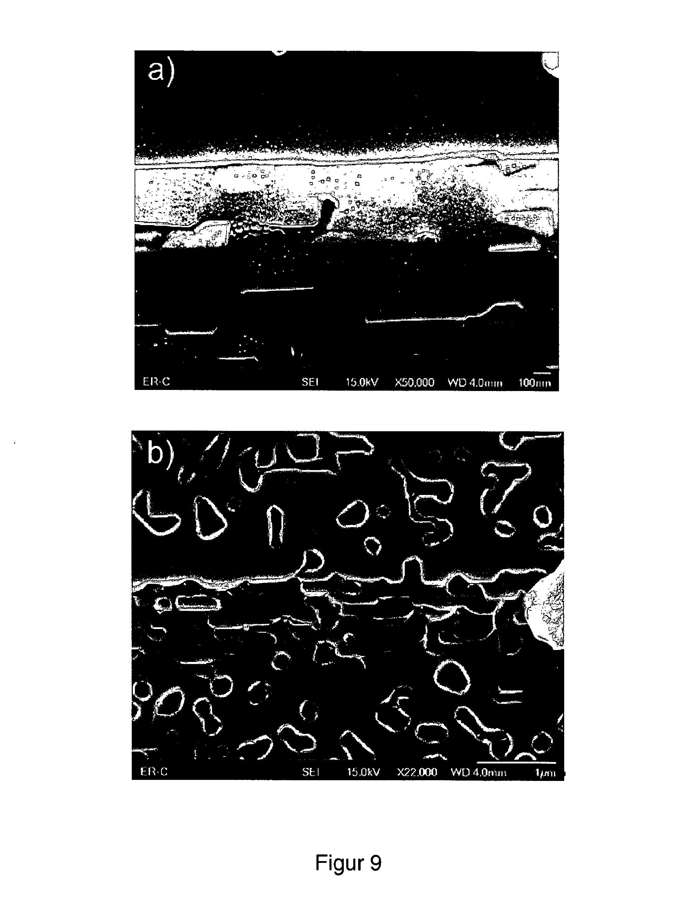

Figur 9 zeigt elektronenmikroskopische Aufsichten auf die Funktionsschichten zweier erfindungsgemäßer Bauelemente ohne (a) und mit (b) Sperrschicht und Keimschicht. Bei dem Bauelement mit Sperrschicht und Keimschicht sind nur wenige Defekte sichtbar. Bei dem Bauelement ohne Sperrschicht und Keimschicht haben chemische Reaktionen mit eindiffundiertem Magnesium aus dem Substrat viele Löcher in die Funktionsschicht gefressen. Das Produkt J_{c}*Rₙ ist für das Bauelement ohne Sperrschicht und Keimschicht mit 300 µV bei 77 K bereits deutlich verbessert gegenüber dem Stand der Technik, obwohl viele mögliche Strompfade in der Funktionsschicht durch die Löcher unterbrochen sind. Mit Sperrschicht und Keimschicht wird das Produkt J_{c}*Rₙ auf etwa 1 mV bei 77 K gesteigert. Analog ist die kritische Temperatur T_{c} des Bauelements mit Sperrschicht und Keimschicht um etwa 10 K höher als beim Bauelement ohne Sperrschicht und Keimschicht.

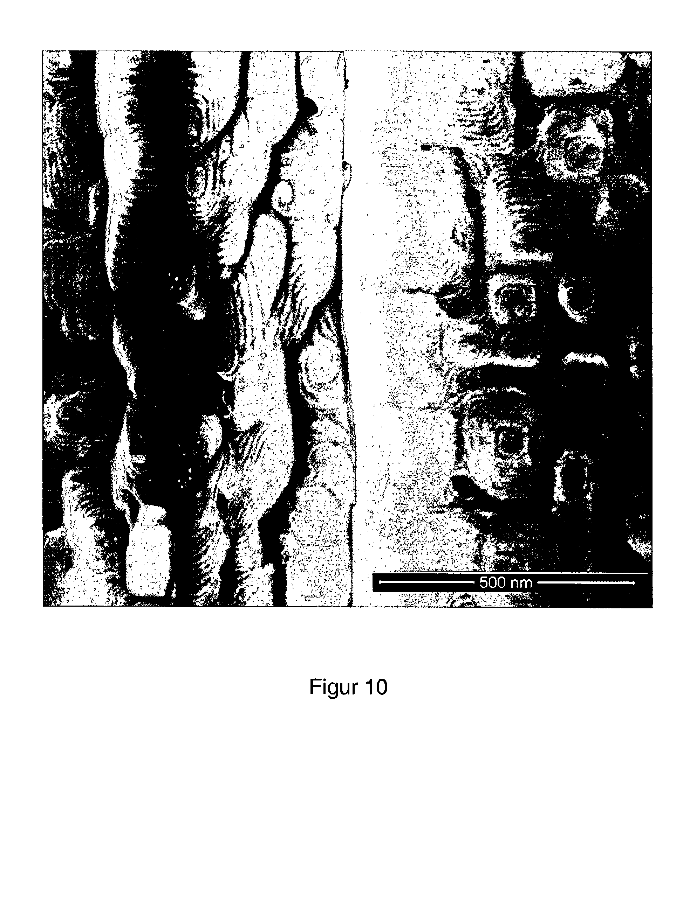

Figur 10 zeigt eine Elektronenmikroskopische Aufnahme einer YBCO-Schicht, die mit Texturierung und YBCO-Keimschicht und SrTiO₃-Sperrschicht, aber ohne antiepitaktische Pufferschicht auf einem MgO-Substrat mit einer 45-Grad-Stufe aufgewachsen wurde, die zwei plane Bereiche des Substrats trennt. Indem die Schicht in den planen Bereichen rechts und links der Stufe eine erste Orientierung [001] des Substrats angenommen hat und im Bereich der Stufe eine zweite [011], haben sich an beiden Übergängen der Stufe zu den planen Bereichen zwei Korngrenzen gebildet, an denen sich die Kristallorientierung der YBCO-Funktionsschicht jeweils um den gleichen Winkel θ=45° ändert. Im Vergleich zu Figur 6, die die gleiche Aufsicht auf eine ohne Sperrschicht und Keimschicht hergestellte Funktionsschicht zeigt, ist ein noch größerer Anteil der Körner mit seiner *a*-Achse senkrecht auf die in der Bildmitte von oben nach unten verlaufenden Stufenkante orientiert und weniger Y2BaCuO Phase (Grünephase) gebildet. Figur 10 wurde in verschieden hellen Bereichen unterschiedlich kontrastverstärkt, um so viele Körner wie möglich erkennbar zu machen. Die YBCO-Schichten weisen zwei Orientierungen gegenüber der [001] Orientierung des MgO-Substrats auf: 0 Grad in den planen Bereichen und 45 Grad auf der Stufe.

## Patentansprüche

1. Bauelement mit einem Josephson-Kontakt, der ein Weak-Link aufweist, umfassend ein Substrat mit mindestens einer Stufenkante in seiner Oberfläche und eine darauf angeordnete Funktionsschicht aus einem hochtemperatursupraleitenden Material, wobei diese Schicht an der Stufenkante eine Korngrenze aufweist, die das Weak-Link des Josephson-Kontakts bildet, wobei auf beiden Seiten der Stufenkante die *a*- und/oder die *b*-Kristallachse in der Ebene der hochtemperatursupraleitenden Funktionsschicht durch eine Texturierung des Substrats und/oder mindestens einer zwischen dem Substrat und der hochtemperatursupraleitenden Funktionsschicht angeordneten Pufferschicht bis auf eine Abweichung von höchstens 10° senkrecht auf die Korngrenze ausgerichtet ist,
**dadurch gekennzeichnet, dass**
die Texturierung Erhebungen und/oder Vertiefungen mit einer mittleren Höhe bzw. Tiefe zwischen 1 nm und 10 nm, bevorzugt zwischen 1 nm und 5 nm, umfasst.

2. Bauelement mit einem Josephson-Kontakt, der ein Weak-Link aufweist, umfassend ein Substrat mit mindestens einer Stufenkante in seiner Oberfläche und eine darauf angeordnete Funktionsschicht aus einem hochtemperatursupraleitenden Material, wobei diese Schicht an der Stufenkante eine Korngrenze aufweist, die das Weak-Link des Josephson-Kontakts bildet,
**dadurch gekennzeichnet, dass**
die hochtemperatursupraleitende Funktionsschicht graphoepitaktisch auf ein texturiertes Substrat und/oder eine zwischen dem Substrat und der hochtemperatursupraleitenden Funktionsschicht angeordnete texturierte Pufferschicht aufgewachsen ist, wobei durch die Texturierung auf beiden Seiten der Stufenkante die *a*- und/oder die *b-*Kristallachse in der Ebene der hochtemperatursupraleitenden Funktionsschicht bis auf eine Abweichung von höchstens 10° senkrecht auf die Korngrenze ausgerichtet ist.

3. Bauelement nach einem der Ansprüche 1 bis 2, **dadurch gekennzeichnet, dass** die Orientierung der Texturierung des Substrats bzw. der Pufferschicht von der durch die Kristallstruktur des Substrats bzw. der Pufferschicht vorgegebenen Orientierung verschieden ist.

4. Bauelement nach einem der Ansprüche 1 bis 3, **dadurch gekennzeichnet, dass** zwischen der hochtemperatursupraleitenden Funktionsschicht und dem Substrat eine antiepitaktische Pufferschicht angeordnet ist, wobei diese antiepitaktische Pufferschicht entweder amorph ist oder eine nicht zum Substrat und/oder zur hochtemperatursupraleitenden Funktionsschicht epitaxiekompatible Kristallstruktur aufweist, so dass die *c-*Achse der hochtemperatursupraleitenden Funktionsschicht bis auf eine Abweichung von höchstens 10° senkrecht auf der Oberfläche dieser Schicht steht.

5. Bauelement nach Anspruch 4, **dadurch gekennzeichnet, dass** die antiepitaktische Pufferschicht eine Dicke von 10 nm oder weniger, bevorzugt von 1 nm oder weniger und ganz besonders bevorzugt von 0,5 nm oder weniger, aufweist und/oder dass jede Gitterkonstante der antiepitaktischen Pufferschicht in der Schichtebene näher an den Gitterkonstanten a und b in der Ebene der hochtemperatursupraleitenden Funktionsschicht liegt als an jedem ganzzahligen Vielfachen oder Teiler der Gitterkonstanten c dieser Schicht und/oder dass die antiepitaktische Pufferschicht texturiert ist.

6. Bauelement nach einem der Ansprüche 4 bis 5, **dadurch gekennzeichnet, dass** zwischen dem Substrat und der antiepitaktischen Pufferschicht oder zwischen der antiepitaktischen Pufferschicht und der hochtemperatursupraleitenden Funktionsschicht eine weitere texturierte Pufferschicht angeordnet ist.

7. Bauelement nach einem der Ansprüche 1 bis 6, **dadurch gekennzeichnet, dass** eine texturierte Pufferschicht als alleinige Pufferschicht unmittelbar zwischen dem Substrat und der hochtemperatursupraleitenden Funktionsschicht angeordnet ist.

8. Bauelement nach Anspruch 6, **dadurch gekennzeichnet, dass** die texturierte Pufferschicht um mindestens 20 %, bevorzugt um mindestens 50 % und ganz besonders bevorzugt um mindestens 100 % dicker ist als die antiepitaktische Pufferschicht und/oder dass die texturierte Pufferschicht eine Dicke von 10 nm oder weniger, bevorzugt von 1 nm oder weniger und ganz besonders bevorzugt von 0,5 nm oder weniger, aufweist und/oder dass die texturierte Pufferschicht in ihrer Ebene eine Gitterkonstante aufweist, die zwischen 90 % und 100 % der Gitterkonstanten der hochtemperatursupraleitenden Funktionsschicht entlang einer ihrer Achsen *a* oder *b* in der Schichtebene beträgt und/oder dass die Texturierung Erhebungen und/oder Vertiefungen mit einer mittleren Höhe bzw. Tiefe zwischen 1 nm und 10 nm, bevorzugt zwischen 1 nm und 5 nm, umfasst.

9. Bauelement nach einem der Ansprüche 1 bis 8, **dadurch gekennzeichnet, dass** der Krümmungsradius des Substrats an der Stufenkante 10 nm oder weniger, bevorzugt 5 nm oder weniger und ganz besonders bevorzugt 1 nm oder weniger, beträgt und/oder dass die Stufenkante einen planen Oberflächenbereich von einem gekrümmten Oberflächenbereich trennt und/oder dass der Krümmungsradius des gekrümmten Bereiches 10 nm oder mehr, bevorzugt 100 nm oder mehr und ganz besonders bevorzugt 1 µm oder mehr, beträgt.

10. Bauelement nach einem der Ansprüche 1 bis 9, **dadurch gekennzeichnet, dass** die Stufe zwei plane Bereiche des Substrats mit einer ersten Orientierung trennt und gegenüber diesen planen Bereichen so geneigt ist, dass auf ihr die hochtemperatursupraleitende Funktionsschicht eine andere, aber im Bereich der Stufe konstante, Kristallorientierung des Substrats annimmt.

11. Bauelement nach einem der Ansprüche 1 bis 10, **dadurch gekennzeichnet, dass** die Oberfläche des Substrats an der Stufenkante um einen Winkel zwischen 20° und 60°, bevorzugt zwischen 30° und 50° und ganz besonders bevorzugt zwischen 35° und 45°, geknickt ist.

12. Bauelement nach einem der Ansprüche 1 bis 11, **dadurch gekennzeichnet, dass** die Texturierung rechteckig oder linienförmig ist.

13. Bauelement nach einem der Ansprüche 1 bis 12, **dadurch gekennzeichnet, dass** das Substrat texturiert ist und zwischen dem Substrat und der hochtemperatursupraleitenden Funktionsschicht eine weitere Keimschicht aus dem Material der Funktionsschicht angeordnet ist, wobei durch die Texturierung auf beiden Seiten der Stufenkante die *a-*und/oder die *b*-Kristallachse in der Ebene der Keimschicht bis auf eine Abweichung von höchstens 10° senkrecht auf die Korngrenze ausgerichtet ist und zwischen der Keimschicht und der hochtemperatursupraleitenden Funktionsschicht eine Sperrschicht angeordnet ist, die für mindestens ein metallisches oder halbleitendes Element des Substrats undurchlässig ist und/oder dass die weitere Keimschicht normalleitend ausgebildet ist und/oder dass die weitere Keimschicht eine Dicke von höchstens 50 nm, bevorzugt zwischen 5 und 20 nm, aufweist und/oder dass die weitere Keimschicht eine Dicke von höchstens 1/3 der Dicke der Funktionsschicht aufweist und/oder dass die Sperrschicht eine Dicke zwischen 1 nm und 1 µm, bevorzugt zwischen 10 und 100 nm und ganz besonders bevorzugt zwischen 20 und 40 nm, aufweist und/oder dass die Sperrschicht eine Perowskitstruktur aufweist.

14. Detektor oder Generator für THz-Strahlung oder supraleitendes Quanteninferferometer, SQUID, **gekennzeichnet durch** mindestens ein Bauelement nach einem der Ansprüche 1 bis 13.

15. Verfahren zur Herstellung eines Bauelements mit einem Josephson-Kontakt aus einem Substrat mit mindestens einer Stufenkante in seiner Oberfläche, wobei eine hochtemperatursupraleitende Funktionsschicht auf die Oberfläche aufgebracht wird, so dass sie sich zu beiden Seiten der Stufenkante erstreckt,
**dadurch gekennzeichnet, dass**
das Substrat texturiert und/oder eine texturierte Pufferschicht auf das Substrat aufgebracht wird und anschließend die hochtemperatursupraleitende Funktionsschicht im Wege der Graphoepitaxie aufgebracht wird, so dass die hochtemperatursupraleitende Funktionsschicht an der Stufenkante eine Korngrenze ausbildet und ihre *a*- und/oder *b-*Achse durch die Texturierung bis auf eine Abweichung von höchstens 10° senkrecht auf die Korngrenze ausgerichtet wird.

16. Verfahren zur Herstellung eines Bauelements mit einem Josephson-Kontakt aus einem Substrat mit mindestens einer Stufenkante in seiner Oberfläche, wobei eine hochtemperatursupraleitende Funktionsschicht auf die Oberfläche aufgebracht wird, so dass sie sich zu beiden Seiten der Stufenkante erstreckt,
**gekennzeichnet durch** folgende Verfahrensschritte:
• das Substrat wird texturiert;
• anschließend wird eine Keimschicht aus dem Material der Funktionsschicht im Wege der Graphoepitaxie aufgebracht, so dass die Keimschicht an der Stufenkante eine Korngrenze ausbildet und ihre *a*- und/oder *b*-Achse **durch** die Texturierung bis auf eine Abweichung von höchstens 10° senkrecht auf die Korngrenze ausgerichtet wird;
• anschließend wird eine Sperrschicht, die für mindestens ein metallisches oder halbleitendes Element des Substrats undurchlässig ist, epitaktisch zur Keimschicht aufgebracht;
• anschließend wird die hochtemperatursupraleitende Funktionsschicht epitaktisch zur Sperrschicht aufgebracht.

17. Verfahren nach einem der Ansprüche 15 bis 16, **dadurch gekennzeichnet, dass** die Orientierung der *c*-Achse der hochtemperatursupraleitenden Funktionsschicht oder der Keimschicht von der Orientierung des Substrats entkoppelt wird, indem vor dem Aufbringen der hochtemperatursupraleitenden Funktionsschicht oder der Keimschicht eine antiepitaktische Pufferschicht aufgebracht wird, die entweder amorph ist oder eine nicht zum Substrat und/oder zur hochtemperatursupraleitenden Funktionsschicht bzw. der Keimschicht epitaxiekompatible Kristallstruktur aufweist.

## Claims

1. Structural element with a Josephson contact, which has a weak link, comprising a substrate with at least a step edge in its surface and a functional layer made of a high temperature superconducting material arranged on it, in which this layer has a grain boundary at the step edge, which forms the weak link of the Josephson contact,
in which through texturing the substrate and/or at least a buffer layer arranged between the substrate and the high temperature superconducting functional layer the *a* and/or *b* crystal axis on both sides of the step edge is aligned perpendicular to the grain boundary in the plane of the high temperature superconducting functional layer up to a deviation of a maximum of 10°,
**characterised in that**
the texturing comprises elevations or and/or recesses with an average height or depth of between 1 nm and 10 nm, preferably between 1 nm and 5 nm.

2. Structural element with a Josephson contact, which has a weak link, comprising a substrate with at least a step edge in its surface and a functional layer made of a high temperature superconducting material arranged on it, in which this layer has a grain boundary at the step edge, which forms the weak link of the Josephson contact,
**characterised in that**
the high temperature superconducting functional layer is grown graphoepitaxially on a textured substrate and/or a textured buffer layer arranged between the substrate and the high temperature superconducting functional layer, in which through the texturing the *a* and/or *b* crystal axis on both sides of the step edge is aligned perpendicular to the grain boundary in the plane of the high temperature superconducting functional layer up to a deviation of a maximum of 10°

3. Structural element according to one of claims 1 to 2, **characterised in that** the orientation of the texturing of the substrate or the buffer layer is different from the orientation preset by the crystal structure of the substrate or the buffer layer.

4. Structural element according to one of claims 1 to 3, **characterised in that** an anti-epitaxial buffer layer is arranged between the high temperature superconducting functional layer and the substrate, in which this anti-epitaxial buffer layer is either amorphous or has a crystal structure that is not epitaxially compatible with the substrate and/or the high temperature superconducting functional layer, so that the c axis of the high temperature superconducting functional layer is perpendicular to the surface of this layer up to a deviation of a maximum of 10°.

5. Structural element according to claim 4, **characterised in that** the anti-epitaxial buffer layer has a thickness of 10 nm or less, preferably 1 nm or less and quite particularly preferably 0.5 nm or less, and/or that each grid constant of the anti-epitaxial buffer layer in the layer plane is closer to grid constants a and b in the plane of the high temperature superconducting functional layer than to any whole number multiple or divider of grid constant c of this layer and/or that the anti-epitaxial buffer layer is textured.

6. Structural element according to one of claims 4 to 5, **characterised in that** a further textured buffer layer is arranged between the substrate and the anti-epitaxial buffer layer or between the anti-epitaxial buffer layer and the high temperature superconducting functional layer.

7. Structural element according to one of claims 1 to 6, **characterised in that** a textured buffer layer is arranged as a single buffer layer directly between the substrate and the high temperature superconducting functional layer.

8. Structural element according to claim 6, **characterised in that** the textured buffer layer is at least 20%, preferably at least 50% and quite particularly preferably at least 100% thicker than the anti-epitaxial buffer layer and/or that the textured buffer layer has a thickness of 10 nm or less, preferably 1 nm or less and quite particularly preferably 0.5 nm or less, and/or that the textured buffer layer has a grid constant in its plane, which amounts to between 90% and 100% of the grid constants of the high temperature superconducting functional layer along one of its axes *a* or *b* in the layer plane and/or that the texturing comprises elevations and/or recesses with an average height or depth of between 1 nm and 10 nm, preferably between 1 nm and 5 nm.

9. Structural element according to one of claims 1 to 8, **characterised in that** the radius of curvature of the substrate at the step edge amounts to 10 nm or less, preferably 5 nm or less and quite particularly preferably 1 nm or less, and/or that the step edge separates a flat surface area from a curved surface area and/or that the radius of curvature of the curved area amounts to 10 nm or more, preferably 100 nm or more and quite particularly preferably 1 µm or more.

10. Structural element according to one of claims 1 to 9, **characterised in that** the step separates two flat areas of the substrate with a first orientation and is slanting in comparison with these flat areas, so that the high temperature superconducting functional layer takes on a crystal orientation of the substrate on it that is different but constant in the area of the step.

11. Structural element according to one of claims 1 to 10, **characterised in that** the surface of the substrate is bent at the step edge at an angle of between 20° and 60°, preferably between 30° and 50° and quite particularly preferably between 35° und 45°.

12. Structural element according to one of claims 1 to 11, **characterised in that** the texturing is rectangular or linear.

13. Structural element according to one of claims 1 to 12, **characterised in that** the substrate is textured and a further germinal layer made of the material of the functional layer is arranged between the substrate and the high temperature superconducting functional layer, in which through the texturing the *a* and/or *b* crystal axis on both sides of the step edge is aligned perpendicular to the grain boundary in the plane of the germinal layer up to a deviation of a maximum of 10° and a barrier layer is arranged between the germinal layer and the high temperature superconducting functional layer, which is impermeable for at least a metallic or semiconducting element of the substrate and/or that the further germinal layer is made normally conducting and/or that the further germinal layer has a thickness of a maximum of 50 nm, preferably between 5 and 20 nm, and/or that the further germinal layer has a thickness of a maximum of 1/3 of the thickness of the functional layer and/or that the barrier layer has a thickness of between 1 nm and 1 µm, preferably between 10 and 100 nm and quite particularly preferably between 20 and 40 nm, and/or that the barrier layer has a perovskite structure.

14. Detector or generator for terahertz radiation or superconducting quantum interference device, SQUID, **characterised by** at least a structural element according to one of claims 1 to 13.

15. Method for producing a structural element with a Josephson contact made of a substrate with at least a step edge in its surface, in which a high temperature superconducting functional layer is applied to the surface, so that it extends to both sides of the step edge,
**characterised in that**
the substrate is applied textured and/or a textured buffer layer is applied to the substrate and then the high temperature superconducting functional layer is applied by means of graphoepitaxy, so that the high temperature superconducting functional layer forms a grain boundary at the step edge and through the texturing its *a* and/or *b* axis is aligned perpendicular to the grain boundary up to a deviation of a maximum of 10°.

16. Method for producing a structural element with a Josephson contact made of a substrate with at least a step edge in its surface, in which a high temperature superconducting functional layer is applied to the surface, so that it extends to both sides of the step edge, **characterised by** the following process steps:
• the substrate is textured;
• then a germinal layer made of the material of the functional layer is applied by means of graphoepitaxy, so that the germinal layer forms a grain boundary at the step edge and through the texturing its *a* and/or *b* axis is aligned perpendicular to the grain boundary up to a deviation of a maximum of 10°;
• then a barrier layer, which is impermeable for at least a metallic or semiconducting element of the substrate, is applied epitaxially to the germinal layer;
• then the high temperature superconducting functional layer is applied epitaxially to the barrier layer.

17. Method according to one of claims 15 to 16, **characterised in that** the orientation of the c axis of the high temperature superconducting functional layer or the germinal layer is decoupled from the orientation of the substrate, **in that** before application of the high temperature superconducting functional layer or the germinal layer an anti-epitaxial buffer layer is applied, which is either amorphous or has a crystal structure that is not epitaxially compatible with the substrate and/or the high temperature superconducting functional layer or the germinal layer.

## Revendications

1. Composant à jonction Josephson, qui présente un maillon faible, comprenant un substrat avec au moins un gradin à sa surface et une couche de fonction qui y est agencée d'un matériau supraconducteur à hautes températures, dans lequel cette couche présente sur le gradin une limite de grain qui forme le maillon faible de la jonction Josephson, dans lequel, sur les deux côtés du gradin, l'axe du cristal a et/ou l'axe du cristal b sont orientés dans le plan de la couche de fonction supraconductrice à hautes températures par une texture du substrat et/ou au moins une couche tampon agencée entre le substrat et la couche de fonction supraconductrice à hautes températures jusqu'à un écart au maximum de 10° perpendiculairement à la limite de grain,
**caractérisé en ce que**
la texture comprend des élévations et/ou des renfoncements d'une hauteur ou d'une profondeur moyenne entre 1 nm et 10 nm, de préférence entre 1 nm et 5 nm.

2. Composant à jonction Josephson, qui présente un maillon faible, comprenant un substrat avec au moins un gradin à sa surface et une couche de fonction qui y est agencée d'un matériau supraconducteur à hautes températures, dans lequel cette couche présente sur le gradin une limite de grain qui forme le maillon faible de la jonction Josephson,
**caractérisé en ce que**
la couche de fonction supraconductrice à hautes températures est déposée par voie graphoépitaxique sur un substrat texturé et/ou une couche tampon texturée agencée entre le substrat et la couche de fonction supraconductrice à hautes températures, dans lequel, par la texture sur les deux côtés du gradin, l'axe du cristal a et/ou l'axe du cristal b sont orientés dans le plan de la couche de fonction supraconductrice à hautes températures jusqu'à un écart au maximum de 10° perpendiculairement à la limite de grain.

3. Composant selon l'une quelconque des revendications 1 à 2, **caractérisé en ce que** l'orientation de la texture du substrat ou de la couche tampon est différente de l'orientation prédéfinie par la structure cristalline du substrat ou de la couche tampon.

4. Composant selon l'une quelconque des revendications 1 à 3, **caractérisé en ce qu'**entre la couche de fonction supraconductrice à hautes températures et le substrat est agencée une couche tampon anti-épitaxique, dans lequel cette couche tampon anti-épitaxique est amorphe ou présente une structure cristalline qui n'est pas compatible au plan épitaxique avec le substrat et/ou la couche de fonction supraconductrice à hautes températures de sorte que l'axe c de la couche de fonction supraconductrice à hautes températures se trouve jusqu'à un écart au maximum de 10° perpendiculairement à la surface de cette couche.

5. Composant selon la revendication 4, **caractérisé en ce que** la couche tampon anti-épitaxique présente une épaisseur de 10 nm ou moins, de préférence de 1 nm ou moins et de façon toute particulièrement préférée de 0,5 nm ou moins, et/ou que chaque constante de réseau de la couche tampon anti-épitaxique se trouve dans le plan de couche plus près des constantes de réseau a et b dans le plan de la couche de fonction supraconductrice à hautes températures que de chaque pluralité entière ou diviseur entier des constantes de réseau c de cette couche, et/ou que la couche tampon anti-épitaxique est texturée.

6. Composant selon l'une quelconque des revendications 4 à 5, **caractérisé en ce qu'**une autre couche tampon texturée est agencée entre le substrat et la couche tampon anti-épitaxique ou entre la couche tampon anti-épitaxique et la couche de fonction supraconductrice à hautes températures.

7. Composant selon l'une quelconque des revendications 1 à 6, **caractérisé en ce qu'**une couche tampon texturée est agencée comme couche tampon unique directement entre le substrat et la couche de fonction supraconductrice à hautes températures.

8. Composant selon la revendication 6, **caractérisé en ce que** la couche tampon texturée est d'au moins 20 %, de préférence d'au moins 50 % et de façon toute particulièrement préférée d'au moins 100 % plus épaisse que la couche tampon anti-épitaxique et/ou que la couche tampon texturée présente une épaisseur de 10 nm ou moins, de préférence de 1 nm ou moins et de façon toute particulièrement préférée de 0,5 nm ou moins, et/ou que la couche tampon texturée présente dans son plan une constante de réseau qui atteint entre 90 % et 100 % des constantes de réseau de la couche de fonction supraconductrice à hautes températures le long d'un de ses axes a ou b dans le plan de couche et/ou que la texture comprend des élévations et/ou des renfoncements d'une hauteur ou d'une profondeur moyenne entre 1 nm et 10 nm, de préférence entre 1 nm et 5 nm.

9. Composant selon l'une quelconque des revendications 1 à 8, **caractérisé en ce que** le rayon de courbure du substrat sur le gradin atteint 10 nm ou moins, de préférence 5 nm ou moins et de façon toute particulièrement préférée 1 nm ou moins, et/ou que le gradin sépare une zone de surface plane d'une zone de surface courbe et/ou que le rayon de courbure de la zone courbe atteint 10 nm ou plus, de préférence 100 nm ou plus et de façon toute particulièrement préférée 1 µm ou plus.

10. Composant selon l'une quelconque des revendications 1 à 9, **caractérisé en ce que** le palier sépare deux zones planes du substrat d'une première orientation et est incliné par rapport à ces zones planes de sorte que sur elle la couche de fonction supraconductrice à hautes températures reçoive une autre orientation cristalline, mais constante dans la zone du palier, du substrat.

11. Composant selon l'une quelconque des revendications 1 à 10, **caractérisé en ce que** la surface du substrat est infléchie sur le gradin d'un angle entre 20° et 60°, de préférence entre 30° et 50°, de façon toute particulièrement préférée entre 35° et 45°.

12. Composant selon l'une quelconque des revendications 1 à 11, **caractérisé en ce que** la texture est rectangulaire ou en forme de lignes.

13. Composant selon l'une quelconque des revendications 1 à 12, **caractérisé en ce que** le substrat est texturé et il se trouve entre le substrat et la couche de fonction supraconductrice à hautes températures une autre couche germe du matériau de la couche de fonction, dans lequel, par la texture sur les deux côtés du gradin, l'axe du cristal a et/ou l'axe du cristal b sont orientés dans le plan de la couche germe jusqu'à un écart au maximum de 10° perpendiculairement à la limite de grain et il se trouve entre la couche germe et la couche de fonction supraconductrice à hautes températures une couche d'arrêt qui est étanche à au moins un élément métallique ou semi-conducteur du substrat et/ou que l'autre couche germe est conçue avec une conduction normale et/ou que l'autre couche germe a une épaisseur au maximum de 50 nm, de préférence entre 5 et 20 nm, et/ou que l'autre couche germe a une épaisseur au maximum de 1/3 de l'épaisseur de la couche de fonction et/ou que la couche d'arrêt présente une épaisseur entre 1 nm et 1 µm, de préférence entre 10 et 100 nm et de façon toute particulièrement préférée entre 20 et 40 nm, et/ou que la couche d'arrêt présente une structure de pérovskite.

14. Détecteur ou générateur pour rayonnement THz ou interféromètre quantique supraconducteur, SQUID, **caractérisé par** au moins un composant selon l'une quelconque des revendications 1 à 13.

15. Procédé de fabrication d'un composant avec une jonction Josephson à partir d'un substrat ayant au moins un gradin à sa surface, dans lequel une couche de fonction supraconductrice à hautes températures est appliquée sur la surface de sorte qu'elle s'étende des deux côtés du gradin,
**caractérisé en ce que**
le substrat est texturé et/ou une couche tampon texturée est appliquée sur le substrat et ensuite la couche de fonction supraconductrice à hautes températures est appliquée par grapho-épitaxie de sorte que la couche de fonction supraconductrice à hautes températures forme sur le gradin une limite de grain et que son axe a et/ou son axe b soient orientés par la texture jusqu'à un écart au maximum de 10° perpendiculairement à la limite de grain.

16. Procédé de fabrication d'un composant avec une jonction Josephson à partir d'un substrat ayant au moins un gradin à sa surface, dans lequel une couche de fonction supraconductrice à hautes températures est appliquée sur la surface de sorte qu'elle s'étende des deux côtés du gradin,
**caractérisé par** les étapes de procédé suivantes :
- le substrat est texturé ;
- ensuite un couche germe du matériau de la couche de fonction est appliquée par grapho-épitaxie de sorte que la couche germe forme sur le gradin une limite de grain et que son axe a et/ou son axe b soient orientés par la texture jusqu'à un écart au maximum de 10° perpendiculairement à la limite de grain ;
- ensuite une couche d'arrêt, qui est étanche au moins à un élément métallique ou semi-conducteur du substrat, est appliquée par voie épitaxique sur la couche germe ; et
- ensuite la couche de fonction supraconductrice à hautes températures est appliquée par voie épitaxique sur la couche d'arrêt.

17. Procédé selon l'une quelconque des revendications 15 à 16, **caractérisé en ce que** l'orientation de l'axe c de la couche de fonction supraconductrice à hautes températures ou de la couche germe est désaccouplée de l'orientation du substrat en appliquant, avant le dépôt de la couche de fonction supraconductrice à hautes températures ou de la couche germe, une couche tampon anti-épitaxique, qui est amorphe ou présente une structure cristalline qui n'est pas compatible au plan épitaxique avec le substrat et/ou la couche de fonction supraconductrice à hautes températures ou la couche germe.
